# EUROPÄISCHE PATENTANMELDUNG

(11) **EP 3 875 638 A1**
(43) Veröffentlichungstag der Anmeldung: **08.09.2021**
(21) Anmeldenummer: 20172923.3
(22) Anmeldetag: 05.05.2020
(51) Int. Cl.: C25D 21/18, C25D 21/22, C25C 3/00, C25D 21/14, C25D 3/38

(54) **VERFAHREN ZUM AUFBEREITEN EINES FREMDMETALL- UND METALLSALZ-HALTIGEN MEDIUMS AUS DER LEITERPLATTEN- UND/ODER SUBSTRAT-HERSTELLUNG**

(30) Priorität: 04.03.2020 EP 20160862
(71) Anmelder: AT & S Austria Technologie & Systemtechnik Aktiengesellschaft, 8700 Leoben-Hinterberg (AT)
(72) Erfinder: Klocek, Jolanta, 8712 Niklasdorf (AT); Payerl, Claudia, 8020 Graz (AT); Frey, Gerhard, 8793 Trofaiach (AT); Schrei, Martin, 8382 Mogersdorf (AT); Redl, Alois, 8712 Niklasdorf (AT); Ebinger, Christoph, 70599 Stuttgart (DE); Herzog, René, 8045 Graz (AT); Zanker, Andreas, 8753 Fohnsdorf (AT); Mandl, Thomas, 8720 Knittelfeld (AT); Gross, Friedrich, 8700 Leoben (AT); Kern, Konstantin, 8700 Leoben (AT); Moitzi, Heinz, 8740 Zeltweg (AT)
(74) Vertreter: Dilg, Haeusler, Schindelmann Patentanwaltsgesellschaft mbH

(57) **Zusammenfassung**

Es wird ein Verfahren (200) beschrieben zum Aufbereiten eines Fremdmetall- und Metallsalz-haltigen Mediums (21) aus der Leiterplatten- und/oder Substrat-Herstellung (insbesondere aus einem Galvanisierungsprozess), das Verfahren weist auf: i) Bereitstellen des Fremdmetall- und Metallsalz-haltigen Mediums (21), und ii) zumindest teilweises Separieren (220) des Fremdmetalls (insbesondere Eisen) aus dem Fremdmetall- und Metallsalz-haltigen Medium (21), um ein Metallsalz-haltiges Medium (20) bereitzustellen.

## Beschreibung

Die Erfindung betrifft ein Verfahren zum Aufbereiten eines Fremdmetall- und Metallsalz-haltigen Mediums aus der Leiterplatten- und/oder Substrat-Herstellung, insbesondere aus einem Galvanisierungsprozess. Weiterhin betrifft die Erfindung eine Vorrichtung, insbesondere eine Industrieanlage, zum Ausführen des Verfahrens. Ferner betrifft die Erfindung ein Verwenden des Fremdmetall- und Metallsalz-haltigen Mediums als Ausgangsmaterial für eine Eisenchlorid Produktion. Außerdem betrifft die Erfindung eine Prozesskontrollvorrichtung zum Regulieren des Verfahrens und/oder der Vorrichtung. Weiterhin betrifft die Erfindung ein Computerprogramm-Produkt zum Steuern des Verfahrens und/oder der Vorrichtung und/oder der Prozesskontrollvorrichtung.

Die Erfindung kann sich somit auf das technische Gebiet der Leiterplatten- und/oder Substrat-Herstellung beziehen. Insbesondere kann sich die Erfindung auf das technische Gebiet des Aufbereitens von Metallsalz-haltigem Medium aus der Leiterplatten- und/oder Substrat-Herstellung beziehen. Weiter kann sich die Erfindung auf das technische Gebiet des Recycelns innerhalb der Leiterplatten- und/oder Substrat-Herstellung beziehen.

Für die Erzeugung von Leiterplatten und/oder Substraten werden prinzipiell große Mengen an Metallen, insbesondere Schwermetallen (z.B. Kupfer, Nickel, Gold, Silber, Palladium, Zinn, Eisen) benötigt. Innerhalb des Herstellungsprozesses fallen daher aus den unterschiedlichen Prozessen Metall-haltige Rückstände bzw. Metall-haltige Medien (insbesondere Lösungen) an.

Die aufzubereitenden Metall (-salz)-haltigen Medien (bzw. zu reinigenden Abfall- und Rückstandskonzentrate) stammen im Wesentlichen aus zwei unterschiedlichen Verarbeitungsprozessen bei der Leiterplatten- und/oder Substrat-Herstellung: i) dem Ätzprozess (z.B. Ätzen von Kupferfolien) und ii) dem Galvanikprozess (z.B. Galvanisieren mit Kupferschichten). Zudem fallen aufzubereitende Metall (-salz)-haltige Medien während Spülprozessen sowohl aus dem Ätzprozess als auch aus dem Galvanikprozess an. Diese Spülwässer enthalten nur geringe Konzentrationen an Metall, insbesondere Kupfer. Die aufzubereitenden Metall (-salz)-haltigen Medien aus den Ätzprozessen und den Galvanikprozessen weisen hingegen vergleichsweise hohe Konzentrationen an Metall auf.

Ein aufzubereitendes Metall (-salz)-haltiges Medium aus dem Galvanikprozess enthält gewöhnlich ebenfalls ein Metallsalz, in welchem das Metall mit dem Salz einer Säure der Elektrolyse chemisch verbunden vorliegt (beispielsweise Kupfersulfat, wobei das Sulfat aus Schwefelsäure stammt). Zusätzlich weist ein aufzubereitendes Metall (-salz)-haltiges Medium aus dem Galvanikprozess generell Fremdmetalle, beispielsweise Eisen, in hohen Konzentrationen auf. Diese Fremdmetalle können z.B. umfassen: Eisen (Fe³⁺, Fe²⁺), Blei (Pb²⁺), Zinn (Sn²⁺), Molybdän (Mo³⁺), Nickel (Ni²⁺), Kobalt (Co²⁺), Indium (In³⁺), Cadmium (Cd²⁺), Zink (Zn²⁺), Chrom (Cr³⁺), Natrium (Na⁺), Palladium (Pd²⁺).

Es sind zwar prinzipiell Methoden bekannt, Metall aus den beschriebenen Metall (-salz)-haltigen Medien rückzugewinnen. Allerdings ist ein rückgewonnenes Metall für die Leiterplatten- und/oder Substrat-Herstellung nur in hochreiner Form (z.B. 99% bis 99,99%, insbesondere etwa 99,9% rein) von Interesse. Eine solche Rückgewinnung kann z.B. mittels einer Elektrolyse erfolgen. Die oben beschriebenen Metall (-salz)-haltigen Medien sind hierfür allerdings denkbar ungeeignet, denn die Abscheidung von reinem Metall (z.B. Kupfer) ist durch die Zusammensetzung der Metall (-salz)-haltigen Medien behindert und/oder erschwert. So stören bzw. verunmöglichen Fremdmetalle wie Eisen erheblich eine qualitativ hochwertige Elektrolyse. Aus diesem Grund werden konventionell Abfallkonzentrate aus der Leiterplatten- und/oder Substrat-Herstellung auf kostenintensive und wenig umweltfreundliche bzw. nachhaltige Weise entsorgt.

Es ist eine Aufgabe der vorliegenden Erfindung ein kostengünstiges, umweltfreundliches, und nachhaltiges Aufbereiten eines Fremdmetall- und Metallsalz-haltigen Medium aus der Leiterplatten- und/oder Substrat-Herstellung innerhalb eines Wertstoffkreislaufs (Prozess-internes, bevorzugt kontinuierliches, Recycling) auf effiziente und robuste Weise zu ermöglichen.

Diese Aufgabe wird durch die Gegenstände gemäß den unabhängigen Patentansprüchen gelöst. Bevorzugte Ausgestaltungen ergeben sich aus den abhängigen Patentansprüchen.

Gemäß einem Aspekt der vorliegenden Erfindung ist ein Verfahren zum Aufbereiten eines Fremdmetall (-salz)- und Metallsalz-haltigen Mediums (z.B. Eisen (-sulfat) in einem Kupfersulfat Medium) aus der Leiterplatten- und/oder Substrat-Herstellung (insbesondere aus einem Galvanisierungsprozess) beschrieben. Das Verfahren weist auf: i) Bereitstellen des Fremdmetall- und Metallsalz-haltigen Mediums, und ii) (zumindest teilweises) Separieren (z.B. mittels eines Ionentauschers und/oder mittels Auskristallisieren) des Fremdmetalls (insbesondere Eisen) aus dem Fremdmetall- und Metallsalz-haltigen Medium, um ein Metallsalz-haltiges Medium (z.B. im Wesentlichen Eisen-freies Kupfersulfat) bereitzustellen.

Gemäß einem weiteren Aspekt der vorliegenden Erfindung ist eine Vorrichtung (z.B. eine Industrieanlage oder zumindest ein Teil davon) zum Aufbereiten eines Fremdmetall- und Metallsalz-haltigen Mediums aus der Leiterplatten- und/oder Substrat- Herstellung (insbesondere aus einem Galvanisierungsprozess) beschrieben. Die Vorrichtung weist auf: i) ein Speicher-Modul (insbesondere mit einem Oxidier-Modul) zum Bereitstellen des Fremdmetall- und Metallsalz-haltigen Mediums, und ii) ein Separier-Modul (z.B. einen Kationentauscher aufweisend) zum (zumindest teilweisen) Separieren des Fremdmetalls (insbesondere Eisen) aus dem Fremdmetall- und Metallsalz-haltigen Medium, um ein Metallsalz-haltiges Medium bereitzustellen.

Gemäß einem weiteren Aspekt der vorliegenden Erfindung wird ein Verwenden beschrieben eines Fremdmetall (insbesondere Eisen)- und Metallsalz-haltigen Mediums aus einem Galvanisierungsprozess zur Leiterplatten- und/oder Substrat- Herstellung als Ausgangsmaterial zur (kontinuierlichen) Produktion von Eisenchlorid für das Fällen von Fotolack aus der Herstellung von Leiterplatten und/oder Substraten bzw. der Herstellung der Leiterplatten und/oder der Substrate.

Gemäß einem weiteren Aspekt der vorliegenden Erfindung wird eine Prozesskontrollvorrichtung zum Regulieren des oben beschriebenen Verfahrens und/oder der oben beschriebenen Vorrichtung diskutiert. Die Prozesskontrollvorrichtung weist auf: i) eine Datenbank zum Erfassen von zumindest einem Prozessparameter (bzw. einem Ist-Wert), insbesondere einer Mehrzahl von Prozessparametern, aus dem laufenden Prozess, ii) eine Datenmodell-Einheit, welche eingerichtet ist zum Speichern von zumindest einem vorbestimmten Prozessparameter (bzw. einem Soll-Wert), insbesondere einer Mehrzahl von vorbestimmten Prozessparametern, und iii) eine Berechnungsvorrichtung, welche eingerichtet ist zum a) Vergleichen des erfassten Prozessparameters mit dem vorbestimmten Prozessparameter (bzw. der Mehrzahlen miteinander), b) Bestimmen einer Steueroperation, welche auf dem Ergebnis des Vergleichens basiert (beispielsweise aktives Ausgleichen einer Differenz zwischen "Ist"-Wert und "Soll"-Wert), und c) Durchführen der bestimmten Steueroperation (z.B. Flussrate anpassen, etc...).

Gemäß einem weiteren Aspekt der vorliegenden Erfindung wird ein Computerprogramm-Produkt beschrieben zum Steuern eines Verfahrens zum Aufbereiten eines Fremdmetall- und Metallsalz-haltigen Mediums aus der Leiterplatten und/oder Substrat Herstellung, welches Computerprogramm-Produkt, wenn es von einem oder mehreren Prozessoren (bzw. einem oder mehreren Computern) ausgeführt wird, das Verfahren (wie oben beschrieben) und/oder die Vorrichtung (wie oben beschrieben) und/oder die Prozesskontrollvorrichtung (wie oben beschrieben) steuert.

Im Rahmen dieses Dokuments kann unter dem Begriff "Metallsalz-haltiges Medium" insbesondere jegliches (flüssige) Medium verstanden werden, welches ein Metallsalz aufweist. Ein Metallsalz ist eine chemische Verbindung zwischen einem Metall und einer Säure. Beispiele für ein solches Metall können umfassen: Kupfer, Nickel, Gold, Silber, Cobalt, Cadmium, Magnesium, Natrium, Palladium, Zinn. Beispiele für Säuren können umfassen: Schwefelsäure, Salzsäure, Salpetersäure, Phosphorsäure; wobei das Metallsalz entsprechend z.B. als Sulfat, Chlorid, Nitrat, oder Phosphat vorliegt. Entsprechend kann ein Metallsalz z.B. Kupfersulfat oder Kupferchlorid sein. Ein Metallsalz-haltiges Medium kann neben Metallsalz eine Lösung aufweisen, welche z.B. wässrig oder sauer sein kann, in welcher das Metallsalz gelöst ist. Beispielsweise kann das Medium neben Wasser auch Salzsäure und/oder Schwefelsäure aufweisen. In einem Beispiel stammt das Metallsalz-haltige Medium aus der Herstellung von Leiterplatten und/oder Substraten und kann entsprechende Rückstände aufweisen. Ferner kann das Metallsalz-haltige Medium aufbereitet sein, so dass im Wesentlichen nur das Metallsalz vorliegt. In einem bevorzugten Beispiel ist das Metallsalz-haltige Medium (im Wesentlichen) frei von (unerwünschtem) Fremdmetall.

Im Rahmen dieses Dokuments kann unter dem Begriff "Fremdmetall" insbesondere ein Metall verstanden werden, welches in einem Metallsalz-haltigen Medium (gelöst) vorliegt, aber dort (für bestimmte Anwendungen) nicht erwünscht ist. Beispiele für solche Fremdmetalle (bzw. deren Ionen) können je nach Anwendungsfall umfassen: Eisen (Fe³⁺, Fe²⁺), Blei (Pb²⁺), Zinn (Sn²⁺), Molybdän (Mo³⁺), Nickel (Ni²⁺), Kobalt (Co²⁺), Indium (In³⁺), Cadmium (Cd²⁺), Zink (Zn²⁺), Chrom (Cr³⁺), Natrium (Na⁺), Palladium (Pd²⁺). In einem Ausführungsbeispiel soll ein Metallsalz-haltiges Medium derart aufbereitet werden, dass das Metall des Metallsalzes in elementarer Form vorliegt und recycelt werden kann. Hierbei können die Fremdmetalle eine Störung bis Verunmöglichung des Aufbereitens (z.B. mittels Elektrolyse) bewirken, wodurch sich ein vorheriges Entfernen der Fremdmetalle empfehlen kann. In einem exemplarischen Ausführungsbeispiel stammt das Metallsalz-haltige Medium aus einem Galvanisierungsprozess und elementares Kupfer soll aus dem Metallsalz Kupfersulfat gewonnen werden. Bedingt durch den Galvanisierungsprozess kann das Metallsalz-haltige Medium Fremdmetalle, insbesondere Eisen, aufweisen. Fremdmetalle können als Fremdmetallsalz (z.B. Eisensulfat) vorliegen. Dieses kann die Elektrolyse von Kupfersulfat empfindlich stören (hemmt die Kupferabscheidung an der Kathode).

Im Rahmen dieses Dokuments kann unter dem Begriff "Fremdmetall- und Metallsalz-haltiges Medium" insbesondere ein Medium verstanden werden, welches ein Metallsalz-haltiges Medium (wie oben beschrieben) und ein Fremdmetall (wie oben beschrieben) aufweist. In einem Ausführungsbeispiel stammt das Fremdmetall- und Metallsalz-haltige Medium aus der Galvanisierung. Insbesondere ist das Fremdmetall- und Metallsalz-haltige Medium ein stark saures Medium (z.B. mit einem pH-Wert < 1). Dies kann darin begründet sein, dass das Fremdmetall- und Metallsalz-haltige Medium eine starke Säure wie Schwefelsäure in hoher Konzentration (z.B. in dem Bereich 100 bis 200 g/L) aufweist.

Im Rahmen dieses Dokuments kann unter dem Begriff "Leiterplatten- und/oder Substrat-Herstellung" insbesondere ein Prozess verstanden werden zum Herstellen von Leiterplatten und/oder Substraten, welcher in einer Industrieanlage, beispielsweise einer Leiterplattenfabrik, durchgeführt wird. Der Begriff "Leiterplatten" kann sich insbesondere auf gedruckte Leiterplatten (printed circuit board (PCB)) beziehen, während sich der Begriff "Substrate" z.B. auf Substrate für Halbleiter-Chips wie integrierte Schaltkreise oder organische Interposer beziehen kann. Eine Leiterplatten- und/oder Substrat-Herstellung umfasst gewöhnlich einen Ätzprozess, in welchem Metall mittels Ätzens derart entfernt wird, dass erwünschte Metallstrukturen erhalten werden, und einen Galvanisierungsprozess, in welchem Metall mittels Galvanisierens (plating) aufgetragen wird. Ausgangsmaterial für eine Leiterplatten- und/oder Substrat-Herstellung umfasst im Wesentlichen das Metall sowie elektrisch isolierendes Material, meist ein organisches Material wie ein Harz. Das Produkt des Prozesses kann die fertige Leiterplatte bzw. das Substrat sein, oder auch ein Zwischenprodukt.

Im Rahmen dieses Dokuments kann unter dem Begriff "Galvanisierungsprozess" insbesondere ein Prozess innerhalb einer Leiterplatten- und/oder Substrat-Herstellung verstanden werden, bei welchem ein Galvanisieren (englisch: plating) durchgeführt wird. Unter Galvanisieren kann man die elektrochemische Abscheidung metallischer Niederschläge auf Vorrichtungen bezeichnen. Als Vorrichtung dient eine Leiterplatte und/oder ein Substrat, auf welcher der metallische Niederschlag (z.B. Kupfer) z.B. als elektrisch leitfähige Schichtstruktur bzw. Leiterbahn dienen kann. Ferner können z.B. Löcher (Vias) elektrisch leitfähig gemacht werden, indem diese seitlich galvanisiert werden oder mittels Galvanisierung komplett gefüllt werden. In einem Beispiel wird an einem elektrolytischen Bad ein Strom angelegt. Am Pluspol (Anode) befindet sich das Metall, das aufgebracht werden soll (z.B. Kupfer oder Nickel), am Minuspol (Kathode) der zu beschichtende Gegenstand (z.B. eine Leiterplatte). Mittels des elektrischen Stroms lagern sich die Metallionen durch Reduktion auf dem Gegenstand ab. In einem Beispiel kann dieser Prozess als eine Abfolge von elektrolytischen Bädern realisiert werden. Der Galvanisierungsprozess kann hierbei kontinuierlich oder diskontinuierlich (Batch-weise) durchgeführt werden. Gewöhnlich fällt bei diesem Prozess eine Menge Metallsalz-haltigen Mediums als Abfallkonzentrat ("Bleed") an. Dieses enthält generell Prozess-bedingt Fremdmetall und einen hohen Säureanteil, so dass ein Recycling des Metalls (des Metallsalzes) bislang nicht in wirtschaftlicher Weise ermöglicht ist.

Im Rahmen dieses Dokuments kann unter dem Begriff "Separieren" insbesondere verstanden werden, dass eine Komponente aus einem Medium abgetrennt wird, zum Beispiel ein Fremdmetall (-salz) aus einem Fremdmetall- und Metallsalz-haltigen Medium. Beispielsweise kann ein Fremdmetall aus einem Fremdmetall- und Metallsalz-haltigen Medium abgetrennt werden, um ein Metallsalz-haltiges Medium zu erhalten. Bevorzugt kann das Separieren mittels eines (Kationen-) Ionentauschers durchgeführt werden. Beispielsweise kann ein Ionentauscher ein selektives Ionenaustauschharz aufweisen, welches selektiv das Fremdmetall separiert (mittels Adsorption) während das Metallsalz-haltige Medium den Ionentauscher passiert. In einem weiteren Ausführungsbeispiel kann das Separieren mittels (Eindampfen und) Auskristallisieren umgesetzt werden.

Im Rahmen dieses Dokuments kann unter dem Begriff "Prozesskontrollvorrichtung" insbesondere jegliche Vorrichtung (oder Mehrzahl an Vorrichtungen) verstanden werden, welche geeignet ist eine Prozesskontrolle vorzunehmen, wobei der Prozess (zumindest teilweise) eine Leiterplatten- und/oder Substrat-Herstellung betrifft. Insbesondere ist die Prozesskontrollvorrichtung eingerichtet (zumindest teilweise) einen Wertstoffkreislauf zu steuern bzw. zu regeln, bei welchem Rückstände der Produktion derart rückgeführt werden, dass im Wesentlichen keine (Schwermetall und/oder Säure) Abfälle anfallen. Die Prozesskontrollvorrichtung kann hierfür insbesondere eine Datenbank (-Einheit) und eine Datenmodell- Einheit aufweisen, wobei erstere ermittelte Prozessdaten speichert, während letztere vorgesehene erwünschte Prozessdaten speichert. Die Prozesskontrollvorrichtung kann mit einer Vielzahl von Sensoren bzw. Messgeräten gekoppelt sein, um auf diese Weise an verschiedenen Prozessstationen aktuelle Parameter zu bestimmen. Ferner kann die Prozesskontrollvorrichtung eine Berechnungsvorrichtung aufweisen, welche die ermittelten Parameter mit den erwünschten vergleicht und basierend hierauf eine Steueroperation bestimmt und durchführt. In einem bevorzugten Ausführungsbeispiel weist die Prozesskontrollvorrichtung einen selbstlernenden Algorithmus (AI) auf, mittels welchem das Steuern bzw. das Regeln des Prozesses stetig verbessert werden kann.

Im Rahmen dieses Dokuments kann der Begriff im Wesentlichen" derart ausgelegt werden, dass vernachlässigbare Rückstände bzw. Verschmutzungen umfasst sein können, welche nicht mehr über vertretbaren Aufwand entfernbar sind. Diese vernachlässigbaren Rückstände bzw. Verschmutzungen sind in einem Ausführungsbeispiel (bewusst) nicht erwünscht, lassen sich aber auch mit vernünftigem Aufwand nicht mehr entfernen. Beispielsweise kann ein Medium in Einleitqualität im Wesentlichen frei von Schwermetall sein, was derart verstanden werden soll, dass vernachlässigbare Rückstände bzw. Verschmutzungen (z.B. im unteren Prozent-, Promille-, oder sogar ppm-Bereich) vorhanden sein können. Der Fachmann versteht, dass, obwohl diese Rückstände bzw. Verschmutzungen nicht erwünscht sind, sie aber nicht mehr auf Aufwand-technisch vertretbare Weise separiert werden können.

Im Kontext des vorliegenden Dokuments kann der Begriff (gedruckte) Leiterplatte" (PCB) insbesondere einen im Wesentlichen plattenförmigen Komponententräger (dieser kann flexibel, rigide, oder semi-flexibel sein) bezeichnen, welcher gebildet wird, indem mehrere elektrisch leitfähige Schichtstrukturen mit mehreren elektrisch isolierenden Schichtstrukturen laminiert werden, beispielsweise indem Druck angelegt wird und/oder indem thermische Energie zugeführt wird. Als bevorzugte Materialien für die PCB Technologie sind die elektrisch leitfähigen Schichtstrukturen aus Kupfer, wohingegen die elektrisch isolierenden Schichtstrukturen Harz und/oder Glasfasern aufweisen können, sogenanntes Prepreg oder FR4 Material. Die verschiedenen elektrisch leitfähigen Schichtstrukturen können miteinander auf gewünschte Weise verbunden werden, indem Durchgangsöffnungen durch das Laminat gebildet werden, beispielsweise mittels Laserbohrens oder mechanischen Bohrens, und indem diese mit elektrisch leitfähigem Material (insbesondere Kupfer) gefüllt werden, wobei dadurch Vias als Durchgangsöffnung Verbindungen gebildet werden. Neben einer oder mehreren Komponenten, welche in eine gedruckte Leiterplatte eingebettet sein können, ist eine gedruckte Leiterplatte typischerweise konfiguriert zum Aufnehmen von einer oder mehreren Komponenten auf einer oder beiden entgegengesetzten Oberflächen der plattenförmigen gedruckten Leiterplatte. Sie können mit der entsprechenden Hauptoberfläche mittels Lötens verbunden werden. Auch können diese Komponenten eingebettet werden. Ein dielektrischer Teil einer PCB kann Harz mit verstärkenden Strukturen (beispielsweise Glasfasern oder Glaskugeln) umfassen.

Im Kontext des vorliegenden Dokuments kann der Begriff "Substrat" insbesondere einen kleinen Komponententräger bezeichnen, welcher im Wesentlichen dieselbe Größe wie eine Komponente hat (insbesondere einer elektronischen Komponente), welche darauf zu montieren ist (wie bei einem Chip Scale Package (CSP)). Insbesondere kann unter einem Substrat ein Träger für elektrische Verbindungen oder elektrische Netzwerke oder auch ein Komponententräger verstanden werden, welcher mit einer gedruckten Leiterplatte (PCB) vergleichbar ist, allerdings mit einer beträchtlich höheren Dichte von seitlich und/oder vertikal angeordneten Verbindungen. Seitliche Verbindungen sind beispielsweise leitfähige Pfade, wohingegen vertikale Verbindungen beispielsweise Bohrlöcher sein können. Diese seitlichen und/oder vertikalen Verbindungen sind in dem Substrat angeordnet und können verwendet werden, um elektrische und/oder mechanische Verbindungen von gehäusten Komponenten oder ungehäusten Komponenten (beispielsweise Dies) bereitzustellen, insbesondere von IC Chips mit einer gedruckten Leiterplatte oder einer Zwischen-gedruckten Leiterplatte. Somit enthält der Begriff "Substrat" auch "IC Substrate". Ein dielektrischer Teil eines Substrats kann Harz mit verstärkenden Partikeln (beispielsweise verstärkende Kugeln, insbesondere Glaskugeln) umfassen.

Das Substrat oder der Interposer kann aus zumindest einer Glas-Schicht (Silizium (Si)) oder einer fotostrukturierbaren, oder einer trockenätzbaren organischen Schicht bestehen. Als organisches Material/organische Schicht kann beispielsweise ein Epoxid-basiertes Aufbaumaterial (beispielsweise Epoxidbasierter Aufbaufolie) oder Polymerverbindungen wie Polyimid, Polybenzoxazol oder Benzocyclobuten-funktionalisierten Polymeren herangezogen werden.

In einer Ausführungsform ist der Komponententräger ein Laminat-Typ Komponententräger. In einer derartigen Ausführungsform ist der Komponententräger ein Verbund aus mehreren Schichtstrukturen, welche gestapelt sind und miteinander verbunden sind, indem eine Presskraft und/oder Wärme aufgebracht wird.

In einer Ausführungsform weist zumindest eine der elektrisch leitfähigen Schichtstrukturen zumindest eines aus der Gruppe auf bestehend aus Kupfer, Aluminium, Nickel, Silber, Gold, Palladium, Magnesium, und Wolfram. Obwohl Kupfer typischerweise bevorzugt ist, sind auch andere Materialien oder beschichtete Versionen davon möglich, insbesondere beschichtet mit einem supra-leitfähigen Material wie beispielsweise Graphen.

In diesem Dokument kann unter dem Begriff "Schwermetall" insbesondere ein Metall verstanden werden, welches eine Dichte größer als 5,0 g/cm³ (alternativ größer als 4,5 g/cm³) aufweist. Hierzu zählen z.B. Kupfer, Nickel, Cobalt, Gold, Silber, Palladium, Wolfram, Zinn, Zink, Eisen, Blei, Chrom, Rhodium, Cadmium, etc. Nicht als Schwermetall bezeichnet werden nach dieser Definition z.B. Aluminium, Silizium, Natrium, Kalium, Calcium, Magnesium, etc.

In diesem Dokument kann unter dem Begriff "Ätzprozess" insbesondere ein Prozess der Leiterplatten- und/oder Substrat-Herstellung bezeichnet werden, welcher das Ätzen von Metall, insbesondere Kupfer, aufweist, um dadurch eine erwünschte metallische (elektrisch leitfähige) Struktur bereitzustellen. Gemäß einem exemplarischen Ausführungsbeispiel kann dieser Prozess wie folgt durchgeführt werden: ein Fotolack schützt Kupferpfade, die nicht weggeätzt werden sollen, während Kupferflächen, welche weggeätzt werden sollen, nicht mit dem Fotolack bedeckt sind. Zunächst wird hierzu die gesamte Kupferlage mit Fotolack überzogen. Dann wird durch eine Maske hinweg der Fotolack mittels UV-Licht entwickelt. Die Maske lässt nur an Stellen UV-Licht durch, an welchen der Fotolack bestehen bleiben soll (i.e. wo die erwünschten Leiterzüge bereitgestellt werden sollen). Während des Entwickelns vernetzt der Lack (bzw. das Polymer) an diesen Stellen, die mit UV-Licht belichtet wurden. Nach dem Entwickeln kann der Fotolack, welcher nicht belichtet wurde (bzw. nicht entwickelt wurde) einfach herunter gewaschen werden. Anschließend wird das Panel (bzw. die Komponententräger Vorform) geätzt. Der Fotolack schützt dabei die Leiterzüge während das Kupfer, das nicht mit Fotolack bedeckt ist, geätzt/entfernt wird. Wenn der Ätzvorgang vorüber ist, wird der Fotolack entfernt bzw. abgezogen (der Lack ist vernetzt und fest) und die Leiterbahnen bleiben übrig. Der gestrippte Fotolack kann zu einem späteren Zeitpunkt mittels Eisenchlorid gefällt werden.

Gemäß einem exemplarischen Ausführungsbeispiel kann die Erfindung auf der Idee basieren, dass ein kostengünstiges, umweltfreundliches, und nachhaltiges Aufbereiten eines Fremdmetall- und Metallsalz-haltigen Mediums aus der Leiterplatten- und/oder Substrat-Herstellung (insbesondere der Galvanisierung) auf effiziente und robuste Weise (innerhalb eines Wertstoffkreislaufs) ermöglicht ist, wenn das Fremdmetalls (insbesondere Eisen) aus dem Fremdmetall- und Metallsalz-haltigen Medium separiert wird, um ein Metallsalz-haltiges Medium bereitzustellen.

Konventionell werden Abfallkonzentrate aus der Leiterplatten- und/oder Substrat-Herstellung auf kostenintensive und wenig umweltfreundliche bzw. nachhaltige Weise entsorgt. Dies auch deswegen, weil Fremdmetalle wie Eisen eine (zwingend notwendige) qualitativ hochwertige Rückgewinnung (z.B. mittels Elektrolyse) stören oder verunmöglichen. Ferner sind diese Medien gewöhnlich sehr sauer und damit prädestiniert dafür als Sondermüll aufwendig entsorgt zu werden.

Es wurde nun aber überraschend erkannt, dass ein wirtschaftliches Aufbereiten von Fremdmetall- und Metallsalz-haltigen Medien, insbesondere aus der Galvanisierung, ermöglicht ist, wenn das Fremdmetall separiert wird. Dies kann z.B. mittels eines Ionentauschers durchgeführt werden, welcher das Fremdmetall selektiv abtrennt. Dadurch kann ein (im Wesentlichen) Fremdmetall-freies Metallsalz-haltiges Medium erhalten werden, welches einem Aufbereitungsprozess problemlos zugeführt werden kann und dadurch ein effizientes und kostengünstiges Recycling ermöglicht.

Vorteilhafterweise wird das Aufbereiten derart durchgeführt, dass die hohe Säurekonzentration nicht etwa störend wirkt, sondern, dass die Säure selbst als Teil des Aufbereitungsprozesses in dem Wertstoffkreislauf gehalten wird und (z.B. über eine Spülwasseraufbereitung oder direkt in einen Säureprozess) in einem Abtrennstrom rückgeführt wird.

Gemäß vorteilhaften Ausführungsbeispielen kann das separierte Fremdmetall selbst innerhalb des Wertstoffkreislaufes gehalten werden, z.B. kann in einem spezifischen Ausführungsbeispiel durch Regenieren des Ionentauschers kontinuierlich Eisenchlorid produziert werden, welches dann zum Fällen von Fotolack verwendet werden kann.

Während Fremdmetall- und Metallsalz-haltige Medien aus der Leiterplatten- und/oder Substrat-Herstellung (insbesondere der Galvanisierung) also bislang aufgrund der hohen Konzentration an Fremdmetall und Säure als aufwendig zu entsorgendes Abfallprodukt angesehen wurden, wird nun in völligem Gegensatz hierzu beschrieben, dass ein wirtschaftliches, effizientes Rückführen von Metall, Fremdmetall, und Säure innerhalb ein und desselben Produktionsprozesses ermöglicht ist.

Gemäß einem Ausführungsbeispiel weist das Fremdmetall zumindest eines aus der Gruppe auf, welche besteht aus: Eisen, Blei, Zinn, Molybdän, Nickel, Kobalt, Indium, Cadmium, Zink, Chrom, Natrium, Palladium. Dies kann den Vorteil haben, dass Metalle, welche zunächst als störend angesehen werden, in abgetrennter Form wieder zu interessanten Rohstoffen werden. Somit kann ein Abwasser aus der Galvanisierung umfunktioniert werden in ein Rohstofflager wirtschaftlich bedeutender Metalle. In einem Ausführungsbeispiel liegt das Fremdmetall (zumindest teilweise) als Fremdmetallsalz vor.

Gemäß einem weiteren Ausführungsbeispiel ist das Fremdmetall- und Metallsalz-haltige Medium ein stark saures Medium. Insbesondere beträgt der pH-Wert weniger als 3, insbesondere weniger als 2, weiter insbesondere weniger als 1. Dies kann den Vorteil haben, dass ein überraschend effizientes Recycling trotz des sehr hohen Säureanteils ermöglicht ist. Insbesondere kann das stark saure Medium wiederum als Abtrennstrom verwendet werden, um im Prozess benötigte Säure rückzugewinnen (anstatt neue hinzuzufügen).

Gemäß einem weiteren Ausführungsbeispiel weist das Fremdmetall- und Metallsalz-haltige Medium Schwefelsäure (H₂SO₄) auf. Dies insbesondere in einer Konzentration > 50 g/L, insbesondere > 150 g/L. Weiter insbesondere liegt die Konzentration in dem Bereich zwischen 100 und 200 g/L. Dies kann ebenfalls den Vorteil haben, dass ein überraschend effizientes Recycling trotz des sehr hohen Säureanteils ermöglicht ist.

Gemäß einem weiteren Ausführungsbeispiel weist das Metallsalz zumindest ein Metall aus der Gruppe auf, welche besteht aus: Kupfer, Nickel, Cobalt, Palladium, Rhodium, Zinn, Cadmium, Magnesium, Natrium, Silber, Gold. Dies hat den Vorteil, dass elementare Ausgangsstoffe der Leiterplatten- und/oder Substratherstellung auf effiziente Weise rückgewonnen werden können und entsprechend in einem (im Wesentlichen) geschlossenen Kreislauf verbleiben.

Gemäß einem weiteren Ausführungsbeispiel weist das Metallsalz ein Metallsulfat (insbesondere Kupfersulfat, CuSO₄) auf. Dies kann den Vorteil haben, dass ein Massenprodukt (Metallsulfat) der Galvanisierung (im Wesentlichen) vollständig recycelt bzw. innerhalb desselben Prozesses rückgeführt werden kann.

Gemäß einem weiteren Ausführungsbeispiel weist das Verfahren auf: Oxidieren des Fremdmetalls (insbesondere im Falle von Eisen von Fe²⁺ zu Fe³⁺) des Fremdmetall- und Metallsalz-haltigen Mediums. Dies kann den Vorteil haben, dass das Separieren (insbesondere mittels eines Ionentauschers) besonders effektiv durchgeführt werden kann. Beispielsweise im Falle von Eisen hat sich überraschend gezeigt, dass Fe³⁺ an einem Ionentauschharz wie Polystyrol wesentlich besser adsorbiert wird als Fe²⁺. Das Oxidieren kann mittels eines Oxidationsmittels (z.B. Wasserstoffperoxid, Kaliumpermanganat) durchgeführt werden. Besonders vorteilhaft kann die Oxidation mittels Sauerstoff (oder Ozon) durchgeführt werden, denn dann verbleiben keine Rückstände im Medium.

Gemäß einem weiteren Ausführungsbeispiel wird für das Separieren ein Ionentauscher verwendet. Insbesondere weist dieser ein selektives Ionenaustauschharz, weiter insbesondere ein doppel-funktionalisiertes Ionenaustauschharz, auf. Dies kann den Vorteil bringen, dass ein besonders effektives und selektives Separieren ermöglicht ist. Ionentauscher können Materialien umfassen, mit denen gelöste Ionen durch andere Ionen gleicher Ladung (positiv oder negativ) ersetzt werden können. Ionentauscher können z.B. als Säulen, die mit einem Ionenaustauschmaterial gefüllt sind, oder als Membranen realisiert werden, welche mit einer Lösung durchströmt werden. Die auszutauschenden Ionen werden am Ionenaustauschmaterial gebunden bzw. adsorbiert.

In einem Ausführungsbeispiel weist das Trägermaterial des Ionenaustauschharzes des Ionentauscher Polystyrol auf. Dieses weist insbesondere zwei funktionelle Gruppen (doppel-funktionalisiertes Ionenaustauschharz) auf, z.B. i) einen Phosphonsäure-Rest und ii) einen Sulfonsäure-Rest. Die erste Säuregruppe weist dabei einen höheren pKs Wert auf als die zweite Säuregruppe. Die Säure mit dem höheren pKs Wert ist dabei die schwächere Säure und unterzieht sich schwerer einer Protolyse als die Säure mit dem niedrigerem pKs Wert (starke Säure). Dadurch kann während der Regeneration das Fremdmetall leichter vom Harz desorbiert werden.

Gemäß einem Ausführungsbeispiel hat es sich überraschend herausgestellt, dass gerade das Verwenden eines speziellen Ionenaustauschharzes mit zwei funktionellen Gruppen eine (effiziente) Desorption des Fremdmetalls (insbesondere Eisen) ermöglicht. Dies ist insbesondere deswegen beachtenswert, weil Ionenaustauschharze (insbesondere einfach-funktionalisierte) generell zu einer irreversiblen Adsorption des Fremdmetalls (insbesondere Eisen) neigen.

In einem exemplarischen Beispiel ist der Ionenaustauscher zweistufig aufgebaut. Der nachgeschaltete (zweite) Ionenaustauscher nimmt den Metallrest des vorangeschalteten (zu beladenden) Ionenaustauschers auf. Weist der erste Ionentauscher einen erhöhten Metallrest auf, kann dieser regeneriert und anschließend an die nachgeschaltete (zweite) Stelle geschaltet werden.

Gemäß einem weiteren Ausführungsbeispiel weist das Verfahren auf: Beladen des Ionentauschers mit dem Fremdmetall- und Metall-haltigen Medium (insbesondere wobei das Fremdmetall im Wesentlichen oxidiert vorliegt) derart, dass das Fremdmetall im Wesentlichen an dem Ionentauscher verbleibt (insbesondere adsorbiert), um das Metallsalz-haltige Medium bereitzustellen. Auch dies ermöglicht ein besonders effektives und selektives Separieren. In einem Beispiel wird der Ionentauscher mit dem Fremdmetall- und Metallsalz-haltigen Medium beladen, also derart durchströmt, dass das Fremdmetall, z.B. Eisen, an dem Harz des Ionentauschers adsorbiert. Den Ionentauscher verlässt danach Metallsalz-haltiges Medium, welches frei von dem adsorbierten Eisen ist. Dieses kann dann einem Verfahren zum Rückgewinnen des elementaren Metalls aus dem Metallsalz-haltigen Mediums zugeführt werden. In einem Ausführungsbespiel werden zumindest zwei Ionentauscher hintereinander geschaltet.

Gemäß einem weiteren Ausführungsbeispiel weist das Verfahren ferner auf: nachfolgend dem Beladen, Regenerieren des Ionentauschers mittels Strömens einer sauren Lösung durch den Ionentauscher derart, dass das Fremdmetall in der sauren Lösung (insbesondere Salzsäure) gelöst wird und eine Fremdmetallhaltige saure Lösung bereitgestellt wird. Dies hat den Vorteil, dass der Ionentauscher mehrmals verwendet werden kann und, dass das abgetrennte Fremdmetall weiterverwendet werden kann. Das am Ionentauscher adsorbierte Fremdmetall muss jedoch entfernt werden, um den Ionentauscher weiter einsetzen zu können. Dieses Regenerieren kann dadurch ausgeführt werden, dass der Ionentauscher von einer sauren Lösung durchströmt wird, welche das Fremdmetall löst, also desorbiert. Entsprechend wird das Fremdmetall in der durchströmten sauren Lösung gelöst als Fremdmetall-haltige saure Lösung vorliegen.

Während konventionell nur schwache Säuren verwendet werden, um einen Ionentauscher zu regenerieren, wurde überraschend erkannt, dass sehr starke Säuren in hoher Konzentration (z.B. 30%-ige Salzsäure) das Fremdmetall besonders effizient von dem Ionentauschharz desorbieren können. In einem Ausführungsbeispiel hat sich insbesondere im Fall von Eisen der Einsatz konzentrierter Salzsäure (als Regeneriersäure) als besonders vorteilhaft erwiesen. Bei dieser Regeneration kann es zu folgender Reaktion kommen: Fe³⁺ + 4 HCl -> FeCl₃ + HCl + 3 H⁺. Während das Fe³⁺ vom Harz desorbiert wird, und sich mit Cl⁻ umsetzt, verbleibt das H⁺ am Harz. HCl kann hier im Überschuss verwendet werden.

Gemäß einem weiteren Ausführungsbeispiel weist das Verfahren ferner auf: Aufbereiten der Fremdmetall-haltigen sauren Lösung mittels einer Säuredialyse, um ein Fremdmetall-haltiges Dialysat (insbesondere Eisenchlorid-haltig) und ein Säure-haltiges Diffusat bereitzustellen. Dies kann den Vorteil haben, dass Abfallprodukte (Fremdmetall und Säure) des Aufbereitens weiter aufgereinigt und in den Prozess rückgeführt werden können. Die Fremdmetall-haltige saure Lösung (bzw. das Säure-haltige Diffusat mittels Rückführens) kann zu einem mehrfachen Regenerieren des Ionenaustauschers genutzt werden. Hierbei kann die Fremdmetall-haltige saure Lösung in einem exemplarischen Beispiel (bis zu) fünf-sechs Mal als Regenerationsmedium herangezogen werden, bevor diese dann z.B. als Fällungsmittel (siehe unten) genutzt wird.

Gemäß einem weiteren Ausführungsbeispiel weist das Verfahren ferner auf: Bereitstellen der Fremdmetall-haltigen sauren Lösung (insbesondere eines Eisen-haltigen Dialysats) an einen weiteren Prozess der Leiterplatten- und/oder Substrat-Herstellung (insbesondere einem Prozess zum Fällen von Fotolack). Dies kann den Vorteil haben, dass (insbesondere auf kontinuierliche Weise) ohne Zusatzaufwand eine Produktion ohnehin für die Leiterplatten- und/oder Substrat-Herstellung benötigten Substanzen wie Eisenchlorid bereitgestellt ist.

Gemäß einem weiteren Ausführungsbeispiel weist die saure Lösung Salzsäure (HCl), auf und die aufbereitete Fremdmetall-haltige saure Lösung weist Eisenchlorid (FeCl₃) auf. In diesem exemplarischen Ausführungsbeispiel weist das Fremdmetall-haltige Dialysat Eisenchlorid auf (Eisen und Salzsäure). In diesem Sinne kann also das Aufbereiten eines Eisen- und Metallsalz-haltigen Mediums aus einem Galvanisierungsprozess zur Leiterplatten- und/oder Substrat-Herstellung als Ausgangsmaterial verwendet werden zur (bevorzugt kontinuierlichen) Produktion von Eisenchlorid für das Fällen von Polymer-basiertem Fotolack für die gedruckten Leiterplatten und/oder Substrate.

Gemäß einem weiteren Ausführungsbeispiel wird die Säuredialyse mittels Membrandialyse durchgeführt (insbesondere wobei zumindest eine Membran der Membrandialyse eine Wickelmembran oder eine Plattenmembran aufweist). Dies kann den Vorteil haben, dass erprobte Techniken direkt eingesetzt werden können, um eine effiziente Dialyse durchzuführen.

In einem Ausführungsbeispiel ist die Membran semipermeabel und lässt Anionen (z.B. Chlorid) passieren (Anionen-Membran), während Kationen (z.B. Fe²⁺, Fe³⁺) nicht passieren können. Die Membrandialyse kann einen Durchsatz in dem Bereich 0,5 bis 5 L/hm² (insbesondere 1 bis 2 L/hm²) aufweisen. Eine Anionen-Membran kann z.B. mit Brom (Br⁻) funktionalisiert sein, wobei das Trägermaterial beispielsweise PET oder PVC sein kann. In bestimmten Fällen kann die Metallsalz-haltige Lösung Wasserstoffperoxid (H₂O₂) beinhalten. In diesem Fall kann bevorzugt eine oxidationsbeständige Membran genutzt werden, welche z.B. auf PEEK (Polyetheretherketon-Trägermaterial) basiert.

Gemäß einem weiteren Ausführungsbeispiel weist das Verfahren ferner auf: Bereitstellen des Säure-haltigen Diffusats als zweiter Abtrennstrom an zumindest einen Prozess zur Leiterplatten- und/oder Substrat-Herstellung aus der Gruppe, welche besteht aus: einem Verfahren zum Aufbereiten von Spülwässern, einem Ätzprozess, einem Trennprozess, der oben beschriebenen Säuredialyse, dem oben beschriebenen Regenerieren. Dies kann den Vorteil haben, dass das Säure-haltige Diffusat, welches immer noch Kleinstmengen an Metallsalz aufweist, in demselben Herstellungsprozess wiederverwendet werden.

Einerseits kann das Säure-haltige Diffusat aufbereitet werden, um das Metallsalz aufzukonzentrieren und Metallsalz-haltiges Medium bereitzustellen. Andererseits kann das Säure-haltige Diffusat als Abtrennstrom verwendet werden, um Säure an Prozessschritte bereitzustellen, welche Säure benötigen, z.B. den Ätzprozess. Ferner kann das Säure-haltige Diffusat aufgereinigt werden (z.B. in der Säuredialyse) und kann dann mehrmals als Regeneriersäure (insbesondere für den Ionentauscher) verwendet werden.

Gemäß einem weiteren Ausführungsbeispiel weist das Verfahren ferner auf: kontinuierliches Rückführen des Säure-haltigen Diffusats (insbesondere nach einem Aufbereiten) zu der Säuredialyse oder dem Regenerieren des Ionentauschers. Dies kann den Vorteil haben, dass ein kontinuierliches Aufkonzentrieren des Säure-haltigen Diffusats stattfindet bzw. dass der Ionentauscher besonders effizient regeneriert werden kann (und die Fremdmetall-haltige saure Lösung aufkonzentriert wird). In einem Beispiel kann das Säure-haltige Diffusat als Regeneriersäure bis zu fünf Mal, insbesondere bis zu sieben Mal, eingesetzt werden, nachdem es (jeweils) in einer Säuredialyse gereinigt wurde.

Gemäß einem weiteren Ausführungsbeispiel weist das Verfahren ferner auf: (zumindest teilweises) thermisches Separieren (z.B. basierend auf einem unterschiedlichen Löslichkeitsprodukt). Dies hat den Vorteil, dass ein effizientes Separieren bereitgestellt ist, welches mit dem oben beschriebenen Ionentauscher kombiniert werden kann, oder eigenständig betrieben wird.

Gemäß einem weiteren Ausführungsbeispiel weist das Verfahren ferner auf: i) Eindampfen des Fremdmetall- und Metallsalz-haltigen Mediums (welches insbesondere Schwefelsäure aufweist) derart, dass das Metallsalz auskristallisiert und das Fremdmetall (insbesondere Eisen) in einem Fremdmetall-haltigen Medium verbleibt, und ii) Separieren des Fremdmetall-haltigen Mediums von dem Metallsalz (insbesondere Überführen des Metallsalzes in das Metallsalz-haltige Medium).

In einem Ausführungsbeispiel wird das Fremdmetall- und Metallsalz-haltige Medium (insbesondere eine (stark) saure Lösung) derart eingedampft, dass das (erwünschte) Metallsalz auskristallisiert und das (nicht erwünschte) Fremdmetall(salz) im gelösten Zustand in einem Fremdmetall-haltigen Medium verbleibt. Diese Trennung basiert auf dem unterschiedlichen Löslichkeitsprodukt von Metall(salz) und Fremdmetall(salz). Danach wird das Fremdmetall-haltige Medium von dem Metallsalz separiert, und das Metallsalz wird in das (im Wesentlichen Fremdmetall freie) Metallsalz-haltige Medium überführt. Dieser Vorgang kann auch mehrfach wiederholt werden. Besonders vorteilhaft kann dieser Separierungsprozess auch mit dem oben beschriebenen Ionentauscher kombiniert werden.

In einem Ausführungsbeispiel fällt CuSO₄, nicht aber FeSO₄, aus, welcher Umstand auf das unterschiedliche Löslichkeitsprodukt der beiden Verbindungen zurück zu führen ist. Während CuSO₄ bereits bei einer niedrigeren Konzentration ausfällt, bleibt FeSO₄ noch in Lösung.

Gemäß einem weiteren Ausführungsbeispiel wird das Separieren (bzw. der Prozess des Separierens, insbesondere das Beladen und/oder das Regenerieren) kontinuierlich betrieben. Dies kann den besonderen Vorteil haben, dass das Aufbereiten von Fremdmetall- und Metallsalz-haltigem Medium aus der Galvanisierung (zusammen mit weiteren Recycling Prozessen) innerhalb eines ständigen Wertstoffkreislaufes innerhalb einer Leiterplatten- und Substrat-Herstellung betrieben werden kann. Anfallende Reste wie Säure-Diffusate können permanent rückgeführt werden, um ein besonders schnelles und kostengünstiges Betreiben einer Industrieanlage zu ermöglichen.

Gemäß einem weiteren Ausführungsbeispiel weist das Verfahren ferner auf: Aufkonzentrieren des Metallsalzes in dem Metallsalz-haltigen Medium (insbesondere mittels eines Verdunsters, z.B. eines Verdunsterturms). Dies kann den Vorteil haben, dass ein hoch konzentriertes Medium einem Rückgewinnen zugeführt werden kann, wodurch sich der Prozess noch effizienter gestalten lässt.

Gemäß einem weiteren Ausführungsbeispiel weist das Verfahren ferner auf: Rückgewinnen von elementarem Metall aus dem Metallsalz-haltigen Medium in einer Reaktionszelle (insbesondere mittels Elektrolyse). Das elementare Metall (z.B. Kupfer) des Metallsalz-haltigen Mediums soll in der Reaktionszelle in (hoch) reiner Form rückgewonnen werden, um einem/dem Prozess zum Herstellen von Leiterplatten und/oder Substraten erneut zugeführt zu werden. Insbesondere wird das erhaltene elementare Metall in einen/den Galvanisierungsprozess rückgeführt.

In einem anderen exemplarischen Beispiel kann das Metallsalz direkt in den Galvanikprozess rückgeführt werden. Während der Galvanisierung kann das Metall in Form des Metallsalzes dem Elektrolyten zudosiert werden. In diesem speziellen Ausführungsbeispiel kann auf ein Rückgewinnen (z.B. über die Elektrolyse) verzichtet werden. Dies kann dadurch ermöglicht sein, dass ein wesentlicher Teil des Fremdmetalls (insbesondere des Eisens) entfernt worden ist.

Gemäß einem weiteren Ausführungsbeispiel weist die Berechnungsvorrichtung einen selbstlernenden Algorithmus (insbesondere mittels neuronaler Netzwerke) auf zum Vergleichen und/oder zum Bestimmen. Dies kann den Vorteil bereitstellen, dass die Prozesskontrollvorrichtung (zumindest teilweise) selbstständig arbeiten und sich basierend hierauf weiterentwickeln kann. Ein selbstlernender Algorithmus (maschinelles Lernen) kann ein künstliches System sein, welches aus Beispielen (bzw. Anwendungen) lernt und diese (nach oder während einer Lernphase) verallgemeinert. Ein solcher Algorithmus kann z.B. mittels neuronaler Netzwerke realisiert werden.

Gemäß einem weiteren Ausführungsbeispiel i) ist der selbstlernende Algorithmus eingerichtet, die bestimmte Steueroperation automatisch durchzuführen, und/oder ii) der selbstlernende Algorithmus ist eingerichtet die bestimmte Steueroperation einem Benutzer zum Überprüfen bereitzustellen. Dadurch kann sich der Vorteil ergeben, dass der selbstlernende Algorithmus einerseits selbstständig (im Wesentlichen ohne Operator) arbeitet und zugleich kontrollierbar und verbesserungsfähig bleibt.

Gemäß einem weiteren Ausführungsbeispiel ist i) der selbstlernende Algorithmus eingerichtet basierend auf dem Vergleichen einen neuen vorbestimmten Prozessparameter zu bestimmen und automatisch der Datenmodell-Einheit zuzuführen und/oder ii) der selbstlernende Algorithmus ist eingerichtet basierend auf dem Vergleichen einen neuen vorbestimmten Prozessparameter zu bestimmen und dem Benutzer zum Überprüfen bereitzustellen. Dadurch kann sich ebenfalls der Vorteil ergeben, dass der selbstlernende Algorithmus einerseits selbstständig (im Wesentlichen ohne Operator) arbeitet und zugleich kontrollierbar und verbesserungsfähig bleibt.

Gemäß einem weiteren Ausführungsbeispiel ist der selbstlernende Algorithmus eingerichtet, das Ergebnis des Überprüfens durch den Benutzer als Lerngrundlage zu verwenden. Dies kann den Vorteil bereitstellen, dass sich der selbstlernende Algorithmus während dem Betreiben des Verfahrens ständig in einer gewünschten Richtung weiterentwickelt und über die Zeit immer mehr Aufgaben direkt umsetzen kann.

Im Folgenden werden exemplarische Ausführungsbeispiele der vorliegenden Erfindung mit Verweis auf die folgenden Figuren detailliert beschrieben.
Die **Figuren 1 bis 3** zeigen jeweils eine Übersicht der Teilströme beim Herstellen von Leiterplatten und/oder Substraten gemäß Ausführungsbeispielen der Erfindung.
Die **Figur 4** zeigt einen zweiten Aufbereitungsprozess eines Metallsalz-haltigen Mediums aus einem Galvanisierungsprozess aus der Leiterplatten- und/oder Substrat-Herstellung gemäß einem Ausführungsbeispiel der Erfindung.
Die **Figur 5** zeigt eine Übersicht der Aufbereitungsprozesse und des Rückgewinnens bei der Leiterplatten- und/oder Substrat-Herstellung gemäß einem Ausführungsbeispiel der Erfindung.
Die **Figur 6** zeigt eine Prozesskontrollvorrichtung zum Regulieren von zumindest einem Teil des oben beschriebenen Verfahrens (bzw. der Industrieanlage) gemäß einem Ausführungsbeispiel der Erfindung.

Gleiche oder ähnliche Komponenten in unterschiedlichen Figuren sind mit gleichen Bezugsziffern versehen.

Im Folgenden wird ein Prozess beschrieben zum Herstellen von Leiterplatten und/oder Substraten, welcher in einer Industrieanlage, beispielsweise einer Leiterplattenfabrik, durchgeführt wird. Der Begriff "Leiterplatten" kann sich insbesondere auf gedruckte Leiterplatten (printed circuit board (PCB)) beziehen, während sich der Begriff "Substrate" z.B. auf Substrate für Halbleiter-Chips wie integrierte Schaltkreise oder organische Interposer beziehen kann. Dieser Prozess ermöglicht es, dass anfallende Rückstände der Leiterplatten- und/oder Substrat-Herstellung in Teilströmen derart in einem Wertstoffkreislauf transportiert und rückgeführt werden können, dass im Betriebszustand des Verfahrens zum Herstellen von Leiterplatten und/oder Substraten als Abfall (im Wesentlichen) letztlich nur ein Medium in Einleitqualität (insbesondere in Kläranlagen oder Gewässer) anfällt.

Gemäß einem exemplarischen Ausführungsbeispiel liegt das Metallsalz (CuSO₄) aus der Galvanik gelöst in Schwefelsäure vor. Die aus dieser Aufbereitung rückgeführte Schwefelsäure kann für die Regeneration des Ionentauschers der Spülwässer herangezogen werden. Aus dem Ätzprozess liegt das Metallsalz (CuCl₂) gelöst in Salzsäure vor. Aus dem Aufbereitungsprozess kann Salzsäure abgetrennt werden und in den Ätzprozess zurückgeführt werden. Alternativ kann die HCl auch verwendet werden, um die Regeneration des Ionentauschers zur Eisenabtrennung zu betreiben. Aus dem Regenerat des Ionentauschers zur Eisenabtrennung kann wiederum HCl zurückgewonnen werden. Diese kann entweder zur erneuten Regeneration des Ionentauschers zur Eisenabtrennung verwendet werden oder die HCl kann zurück in den Ätzprozess geführt werden.

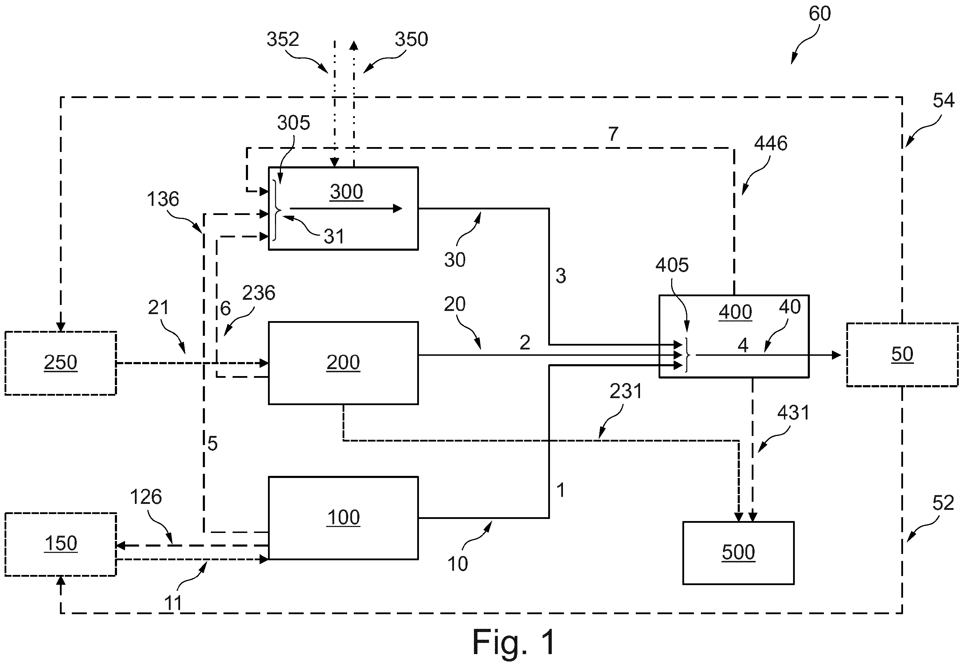

**Figur 1** zeigt eine Übersicht von Strömen 1 bis 7 beim Herstellen von Leiterplatten und/oder Substraten, z.B. in einer Industrieanlage 60, gemäß einem Ausführungsbeispiel der Erfindung. Das Verfahren zum Herstellen von Leiterplatten und/oder Substraten wird derart betrieben, dass die anfallenden Prozess-Rückstände 11, 21, 31 in drei hauptsächlichen Teilströmen 1, 2, 3 (und insbesondere zumindest teilweise als Gesamtstrom 4) und drei hauptsächlichen Abtrennströmen 5, 6, 7 (welche insbesondere Säure-Rückstände aufweisen) derart in einem Wertstoffkreislauf geleitet und rückgeführt (bzw. recycelt) werden, dass in dem (gezeigten) Betriebszustand des Herstellungsverfahrens als Abfall (im Wesentlichen) nur ein Medium 350 in Einleitqualität anfällt. In anderen Worten weist das Medium 350 in Einleitqualität (im Wesentlichen) keine Hauptkomponenten (insbesondere kein Schwermetall) der Leiterplatten/Substrat-Herstellung mehr auf, sondern besteht lediglich aus Wasser, Salzen, und organischem Material. Dem Herstellungsverfahren müssen im (gezeigten) Betriebszustand (im Wesentlichen) also nur Wasser 352 und Energie zugeführt werden (anfallende Säure-Rückstände werden (im Wesentlichen) ebenfalls in dem Wertstoffkreislauf rückgeführt). Im Wesentlichen werden dem Herstellungsverfahren also nur solche Hauptkomponenten (insbesondere Schwermetall wie Kupfer) zugeführt, welche als Bestandteil einer fertigen gedruckten Leiterplatte und/oder eines Substrats das Herstellungsverfahren wieder verlassen. Prinzipiell können in dem beschriebenen Wertstoffkreislauf 95% oder mehr, insbesondere 98% oder mehr, der Schwermetall-Rückstände (z.B. Kupfer Rückstände) rückgeführt werden. In einem exemplarischen Beispiel des Wertstoffkreislauf werden mindestens 80% (insbesondere mindestens 85%, weiter insbesondere mindestens 90%) der abgetrennten Salzsäure rückgeführt, und mindestens 70% (insbesondere mindestens 75%, weiter insbesondere mindestens 80%) der benötigten Schwefelsäure Verfahrens-intern produziert. Daher werden dem Herstellungsverfahren (im Wesentlichen) keine Hauptkomponenten zugegeben, welche als Abfall das Herstellungsverfahren verlassen haben. Tatsächlich fällt ein solcher Abfall (im Wesentlichen) prinzipiell nicht an.

Die anfallenden Rückstände 11, 21, 31 bzw. Abfallkonzentrate können als aufzubereitende Metallsalz-haltige Medien bezeichnet werden und weisen in einem exemplarischen Ausführungsbeispiel u.a. auf: Kupfer, Kupfersulfat, Kupferchlorid, Eisen, Nickel, Gold, Salzsäure, Schwefelsäure. Die aufzubereitenden Metallsalz-haltigen Medien 11, 21, und 31 werden jeweils in einem entsprechenden Aufbereitungsprozess 100, 200, 300 aufbereitet und dann als Teilströme 1, 2, 3, welche jeweils aufbereitetes Metallsalz-haltiges Medium 10, 20, 30 aufweisen, einem Rückgewinnungsprozess 400 zugeführt. Nach der Aufbereitung schließlich wird rückgewonnenes, elementares Metall 50 wieder in den Herstellungsprozess eingespeist (Pfeile 52 und 54). Im Folgenden wird ein prinzipieller Überblick über die Teilströme 1 bis 7 innerhalb des Wertstoffkreislaufs gegeben. Weiter unten folgen dann detaillierte Beschreibungen der einzelnen Prozesse.

Der erste Teilstrom 1 weist ein erstes aufbereitetes Metallsalz-haltiges Medium 10 aus einem Ätzprozess 150 der Leiterplatten- und/oder Substrat-Herstellung auf, welches in einem ersten Aufbereitungsprozess 100 aufbereitet wird. Das erste aufbereitete Metallsalz-haltige Medium 10 (welches im Wesentlichen kein aufzubereitendes Metallsalz aufweist) wird aus dem aufzubereitenden Medium 11 aus dem Ätzprozess 150 erhalten. Das aufzubereitende Medium 11 weist ein aufzubereitendes Metallsalz (z.B. Kupferchlorid) und eine Säure auf. Das Aufbereiten 100 umfasst ein mehrstufiges Entfernen 110, 120 der Säure mittels Membrandialyse und Durchführen einer chemischen Reaktion 140. Bei der Membrandialyse fällt ein erstes Säure-haltiges Diffusat 136 an. Ein weiteres Säure-haltiges Diffusat 126 kann direkt an den Ätzprozess 150 bereitgestellt werden.

Der zweite Teilstrom 2 weist ein zweites aufbereitetes Metallsalz-haltiges Medium 20 aus einem Galvanisierungsprozess 250 der Leiterplatten- und/oder Substrat-Herstellung auf. Das zweite aufbereitete Metallsalz-haltige Medium 20 (welches im Wesentlichen kein Eisen aufweist) wird aus einem Eisen- und Metallsalz-haltigen Medium 21 aus dem Galvanisierungsprozess 250 erhalten. Das Aufbereiten 200 umfasst ein Separieren des Eisens aus dem Eisen- und Metallsalz-haltigen Medium 21 mittels eines Ionentauschers 220. Bei einem Regenerieren 222 des Ionentauschers 220 fällt ein zweites Säure-haltiges Diffusat 236 an.

Der dritte Teilstrom 3 weist ein drittes aufbereitetes Metallsalz-haltiges Medium 30 aus Spülwasser 32 bzw. einer Spülwasser Mischung 31 der Leiterplatten- und/oder Substrat-Herstellung auf. Das dritte aufbereitete Metallsalz-haltige Medium 30 wird in einem dritten Aufbereitungsprozess 300 unter Verwenden eines Ionentauschers 320 erhalten, wobei das Metallsalz in dem aufbereiteten Metallsalz-haltigen Medium 30 im Vergleich zu dem Spülwasser 32 aufkonzentriert ist.

Die Teilströme 1, 2, 3 können (zumindest teilweise) vereint werden (siehe Schritt 405) zu einem Gesamtstrom 4 oder auch einzeln aufbereitet werden. Das Aufbereiten 400 umfasst ein Rückgewinnen 400 des elementaren Metalls 50 (z.B. elementares Kupfer) aus dem Metallsalz-haltigen Medium 40 in einer (Elektrolyse-) Reaktionszelle 450. Das (kontinuierliche) Einstellen der Zusammensetzung des Metallsalz-haltigen Mediums 40 als Elektrolyten umfasst ein Abtrennen 440 von Säure mittels Membrandialyse, wobei ein drittes Säure-haltiges Diffusat 446 anfällt. Alternativ kann das Diffusat 446 auch zur Regeneration eines Ionentauschers 320 zur Aufbereitung der Spülwässer herangezogen werden. Hierbei bleibt das Metall (insbesondere Kupfer) ebenfalls im Wertstoffkreislauf und kann daher nahezu vollständig aus dem Metallsalz-haltigen Medium entfernt werden. Das hat den Vorteil, dass ein weiterer Aufbereitungsschritt mittels Membrandialyse eingespart werden kann. Das erhaltene hochreine Metall 50 wiederum ist geeignet erneut in den Ätzprozess 150 rückgeführt (siehe Pfeil 52) zu werden und/oder in den Galvanisierungsprozess 250 rückgeführt (siehe Pfeil 54) zu werden.

Ein erster Abtrennstrom 5 stammt aus dem ersten Aufbereitungsprozess 100 und weist das erste Säure-haltige Diffusat 136 auf. Ein zweiter Abtrennstrom 6 stammt aus dem zweiten Aufbereitungsprozess 200 und weist das zweite Säure-haltige Diffusat 236 auf. Ein dritter Abtrennstrom 7 stammt aus dem Aufbereitungsprozess 410 des Gesamtstroms 4 und weist das dritte Säure-haltige Diffusat 446 auf. Die Abtrennströme 5, 6, 7 weisen jeweils das Metallsalz (z.B. Kupfersulfat) in geringer Konzentration auf, bzw. in geringerer Konzentration als die Konzentration des Metallsalzes in dem dritten Teilstrom 3. Die Abtrennströme 5, 6, 7 werden (zumindest teilweise) zusammengeführt (siehe Schritt 305) zu einem aufzubereitenden Medium 31 bzw. einer Mischung an Spülwässern (Gesamtabtrennstrom). Auch weitere Spülwässer 32 des Herstellungsverfahrens können hier einfließen. Das aufzubereitende Medium 31 wird, wie oben beschrieben, mittels des dritten Aufbereitungsprozesses 300 aufbereitet, um die Konzentration für das Rückgewinnen 400 deutlich zu erhöhen.

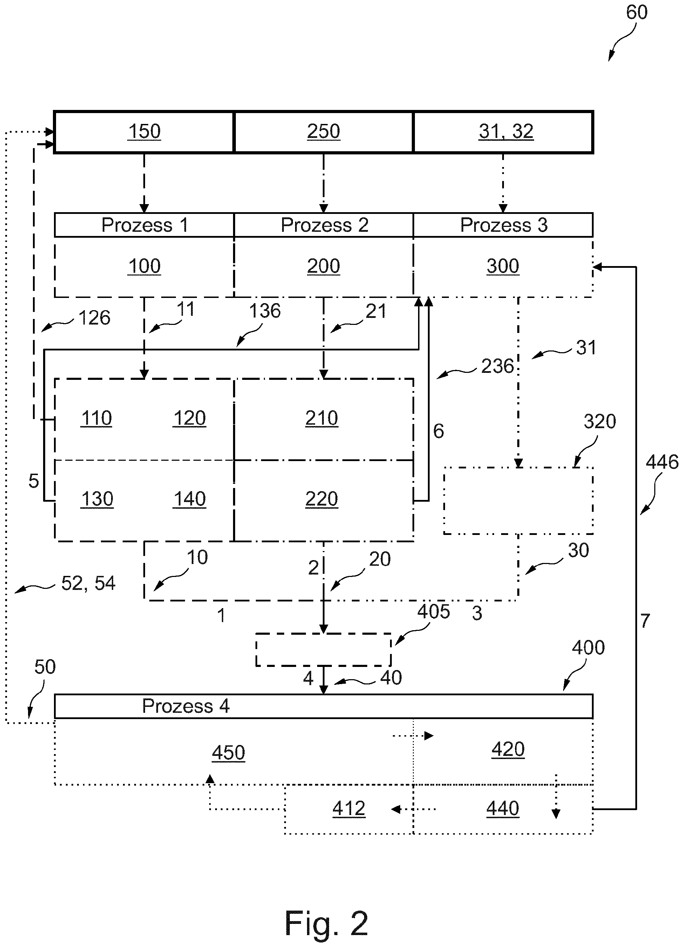

**Figur 2** zeigt eine Übersicht der Teilströme beim Herstellen von Leiterplatten und/oder Substraten, z.B. in einer Industrieanlage 60, gemäß einem weiteren Ausführungsbeispiel der Erfindung. Der Wertstoffkreislauf entspricht dem für Figur 1 oben beschriebenen in anderer Darstellungsweise. Es ist ferner gezeigt, dass das Rückgewinnen 400 ein (kontinuierliches) Einstellen der Zusammensetzung des Elektrolyten (bzw. des Metallsalz-haltigen Mediums) 40 aufweist. So wird der Elektrolyt aus der Reaktionszelle 450 (kontinuierlich) behandelt mittels eines organischen Filters 412, eines Separierens von Fremdmetall 420, und eines Separierens von Säure 440 (bei zu hoher Säurekonzentration).

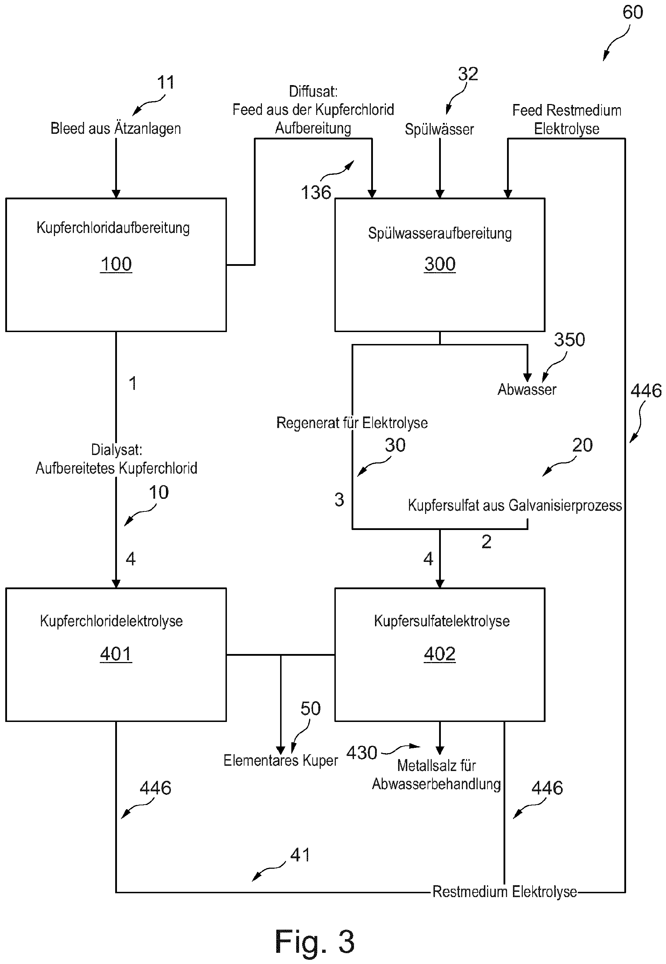

**Figur 3** zeigt ein exemplarisches Ausführungsbeispiel des für die Figuren 1 und 2 bereits beschriebenen Herstellens von gedruckten Leiterplatten und/oder Substraten. In diesem spezifischen Ausführungsbeispiel weist das aufzubereitende Metallsalz Kupferchlorid auf und das Metallsalz weist Kupfersulfat auf. Der Unterschied zu dem für die Figuren 1 und 2 beschriebenen Prozess besteht darin, dass der erste Teilstrom 1 einem ersten Rückgewinnungsprozess 401 (der Begriff "Kupferchloridelektrolyse" bezieht sich hierbei auf das Ausgangsmaterial, es wird eigentlich eine Kupfersulfatelektrolyse durchgeführt) zugeführt wird und ein Gesamtstrom 4, welcher aus dem zweiten Teilstrom 2 und dem dritten Teilstrom 3 besteht, einem zweiten Rückgewinnungsprozess 402 zugeführt wird.

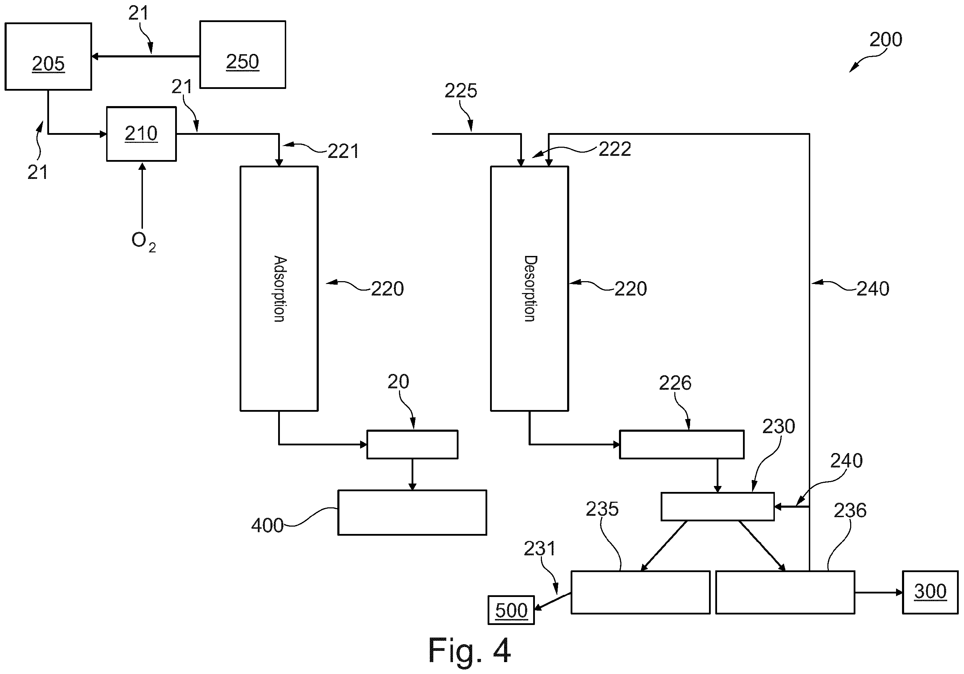

**Figur 4** zeigt den zweiten Aufbereitungsprozess 200 gemäß einem Ausführungsbeispiel der Erfindung, bei welchem ein Fremdmetall (insbesondere Eisen)- und Metallsalz-haltiges Medium 21 aus einem Galvanisierungsprozess 250 aus der Leiterplatten- und/oder Substrat-Herstellung aufbereitet wird, um das zweite Metallsalz-haltige Medium 20 bereitzustellen. Die folgenden Ausführungsbeispiele werden für Eisen als Fremdmetall exemplarisch beschrieben, gelten ebenso aber auch für andere Fremdmetalle, wie z.B.: Blei, Zinn, Molybdän, Nickel, Kobalt, Indium, Cadmium, Zink, Chrom, Natrium, Palladium.

Das Eisen- und Metallsalz-haltige Medium 21 wird zunächst aus dem Galvanisierungsprozess 250 in einem Speicher-Modul 205 bereitgestellt. Das Eisen- und Metallsalz-haltige Medium 21 ist eine stark saure Lösung mit einem pH-Wert unter 3 (insbesondere unter 1), welcher von einer starken Säure (insbesondere Schwefelsäure mit einer Konzentration in dem Bereich 100 bis 200 g/L) verursacht wird.

Als erster Schritt wird eine Oxidation 210 des Eisens von Fe²⁺ zu Fe³⁺ durchgeführt. Bevorzugt geschieht dies in einem Oxidationsmodul 210 mit Sauerstoff als Oxidationsmittel. In einem weiteren Schritt wird das oxidierte Eisen (zumindest teilweise) aus dem Eisen- und Metallsalz-haltigen Medium 21 separiert, um das (im Wesentlichen Eisen-freie) Metallsalz-haltige Medium 20 bereitzustellen. Für das Separieren wird ein Ionentauscher 220 mit einem selektiven Ionenaustauschharz verwendet. Hierfür wird der Ionentauscher 220 mit dem Eisen- und Metallsalz-haltigen Medium 21 beladen (Schritt 221), also derart durchströmt, dass das Eisen an dem Harz des Ionentauschers 220 adsorbiert. Den Ionentauscher 220 verlässt danach das Metallsalz-haltige Medium 20, welches im Wesentlichen Eisen-frei ist. Dieses kann dem Verfahren zum Rückgewinnen 400 des elementaren Metalls 50 aus dem Metallsalz-haltigen Mediums 20 zugeführt werden.

Das am Ionentauscher 220 adsorbierte Eisen muss jedoch entfernt werden, um den Ionentauscher 220 weiter einsetzen zu können. Dieses Regenerieren 222 wird dadurch ausgeführt, dass der Ionentauscher 220 von einer sauren Lösung 225 durchströmt wird, welche das Eisen löst, also desorbiert. Entsprechend wird das Eisen in der durchströmten sauren Lösung 225 gelöst als Eisen-haltige saure Lösung 226 vorliegen. Diese Eisen-haltige saure Lösung 226 wird mittels einer Säuredialyse 230 aufbereitet, um ein Eisen-haltiges Dialysat 235 und ein Säure-haltiges Diffusat 236 bereitzustellen. Die Säuredialyse 230 wird mittels Membrandialyse (z.B. wie oben beschrieben) durchgeführt, insbesondere wobei zumindest eine Membran der Membrandialyse eine Wickelmembran oder eine Plattenmembran aufweist.

Die Eisen-haltige saure Lösung 226 (bzw. das Säure-haltige Diffusat 236 mittels Rückführens 240) kann zu einem mehrfachen Regenerieren des Ionenaustauschers 220 genutzt werden. Hierbei kann die Eisen-haltige saure Lösung 226 in einem exemplarischen Beispiel (bis zu) fünf-sechs Mal als Regenerationsmedium herangezogen werden, bevor diese dann z.B. als Fällungsmittel 231 genutzt wird.

Das Trägermaterial des Ionenaustauschharzes des Ionentauscher 220 ist bevorzugt Polystyrol. Dieses weist insbesondere zwei funktionelle Gruppen (doppel-funktionalisiertes Ionenaustauschharz) auf, z.B. i) einen Phosphonsäure-Rest und ii) einen Sulfonsäure-Rest. Die erste Säuregruppe weist dabei einen höheren pKs Wert auf als die zweite Säuregruppe. Die Säure mit dem höheren pKs Wert ist dabei die schwächere Säure und unterzieht sich schwerer einer Protolyse als die Säure mit dem niedrigerem pKs Wert (starke Säure). Dadurch kann während der Regeneration das Eisen leichter vom Harz desorbiert werden. Gemäß einem Ausführungsbeispiel hat es sich überraschend herausgestellt, dass gerade das Verwenden dieses speziellen Ionenaustauschharzes mit den zwei funktionellen Gruppen eine (effiziente) Desorption des Eisens ermöglicht. Dies ist insbesondere deswegen beachtenswert, weil Ionenaustauschharze (insbesondere einfach-funktionalisierte) teilweise zu einer irreversiblen Adsorption des Eisens neigen.

Das Eisen-haltige Dialysat 235 kann an einen Prozess 500 bei der Leiterplatten- und/oder Substrat-Herstellung weitergeleitet 231 werden. Dieser Prozess 500 kann z.B. ein Fällen von Polymer-basiertem Fotolack (aus einem Abwasser) umfassen. In einem exemplarischen Ausführungsbeispiel weist das Eisen-haltige Dialysat 235 Eisenchlorid auf. In diesem Sinne kann also das Aufbereiten 200 eines Eisen- und Metallsalz-haltigen Mediums 21 aus einem Galvanisierungsprozess 250 zur Leiterplatten- und/oder Substrat-Herstellung als Ausgangsmaterial 231 verwendet werden zur (bevorzugt kontinuierlichen) Produktion von Eisenchlorid für das Fällen von Polymer-basiertem Fotolack für die gedruckten Leiterplatten und/oder Substrate.

Fotolacke bestehen generell aus photo-aktiven Initiatoren und einem Harz, wobei das Harz ein funktionalisiertes Polymer oder ein Copolymer sein kann. Harze für Positivlacke sind z.B. Lacke oder Phenol-Formaldehyd-basierte Polymere wie Novolac. Als Photoinitiator kann z.B. Diazonaphthoquinon (Mischung: DNQ-Novolac) verwendet werden. Harze für Negativlacke umfassen z.B. Harze auf Epoxid-Basis. Ferner gibt es auch Trockenlacke, welche z.B. auf Polyacrylaten basieren. In einem Ausführungsbeispiel lassen sich insbesondere Trockenlacke besonders effizient fällen.

Das Säure-haltige Diffusat 236 kann (insbesondere nach einem Aufbereiten) zu der Säuredialyse 230 oder dem (Säure-) Regenerieren 222 des Ionentauschers 220 rückgeführt werden. Bevorzugt wird das Säure-haltige Diffusat 236 in einem zweiten Abtrennstrom 6 dem Verfahren 300 zum Aufbereiten von Spülwasser aus der Leiterplatten- und/oder Substrat-Herstellung zugeführt. Dies insbesondere deswegen, weil das Säure-haltige Diffusat 236 geringe Konzentrationen des Metalls aus dem Metallsalz-haltigen Medium 20 aufweist.

Gemäß einem exemplarischen Ausführungsbeispiel weisen Eisen- und Metallsalz-haltige Medien 21 (Abfallkonzentrate) aus der Galvanik (Bleed) 250 Kupfersulfat und Schwefelsäure auf. Zusätzlich weisen diese Konzentrationen Eisen in Form von Eisensulfat, Fe²⁺, und Fe³⁺ auf. Während einem Rückgewinnen 400 (z.B. Elektrolyse) wird das Fe²⁺ an der Anode zu Fe³⁺ oxidiert, welches wiederum mit steigender Konzentration die Kupferabscheidung an der Kathode hemmt. Um das zu verhindern, muss das Eisen entweder vorab vom Elektrolyten abgetrennt werden, oder kontinuierlich während der Elektrolyse ausgetragen werden. Damit die Eisen-Ionen effizient mittels Ionenaustauschharz separiert getrennt werden können, werden diese in einem ersten Schritt oxidiert. Dazu wird der mit Eisen belastete Bleed 21 erst in einem Auffangbecken 205 gesammelt und mit einem geeigneten Oxidationsmittel (beispielsweise O₂, H₂O₂, Ozon, KMnO₄) behandelt. Der Vorteil der Behandlung mittels Sauerstoffs ist, dass keinerlei Rückstände vom Oxidationsmittel im Abfallkonzentrat verbleiben. In einem nächsten Schritt wird das aus dem Bleed 21 gewonnene Fe³⁺ mittels des selektiven Ionenaustauschharzes abgetrennt. Mehrere Ionenaustauscher 220 werden dazu in Serie installiert, welche ausschließlich Fe³⁺ am Harz immobilisieren, nicht jedoch Cu²⁺. Sobald der erste, in Reihe geschaltete Ionenaustauscher mit Fe³⁺ vollständig beladen 221 ist, und dieser beginnt durchzubrechen, wird dieser aus der Reihe genommen und mittels speziellem Regenerieren 222 wieder vom Fe³⁺ befreit. Die Abfallkonzentrate werden weiter über die restlichen Ionenaustauscher 220 geleitet. Der vormals zweite, in Serie geschaltete Ionenaustauscher, wird dabei zum Ersten. Beim Beladen des Harzes wird daher zurückgehaltenes Eisen von Kupfer getrennt. Der Ablauf 20 besteht in diesem Fall aus dem mit Kupfer beladenen Metallsalz-haltigen Medium 20, während das Eisen bis zur Regeneration 222 am Harz verbleibt. Das Metallsalz-haltige Medium 20 enthält Kupfer in Form von Kupfersulfat und Schwefelsäure. Die Regeneration des Harzes erfolgt mittels 30%-iger Salzsäure im Überschuss, welche mittels anschließender Säuredialyse 230 zurückgewonnen werden kann. Diese kann dadurch noch für beispielsweise sieben weitere Regenerationsschritte 222 verwendet werden. Bei der Regeneration 222 kommt es zu der Reaktion: Fe³⁺ + 4 HCl -> FeCl₃ + HCl + 3 H⁺. Das mittels der Säuredialyse 230 abgetrennte Eisenchlorid kann in einer Abwasseranlage des Prozesses 500 zur Fällung von Fotolack (polymerbasierten Trockenlacken) verwendet werden.

Eine weitere Methodik, um das störende Eisen abzutrennen, besteht in einem thermischen Separieren (nicht gezeigt), z.B. Auskristallisieren. Hierfür wird das Eisen- und Metallsalz-haltige Medium 21 derart eingedampft, dass das Metallsalz auskristallisiert und das Eisen in einem Eisen-haltigen Medium verbleibt. Danach wird das Eisen-haltige Medium von dem Metallsalz separiert, und das Metallsalz in das Metallsalz-haltige Medium 20 überführt.

Gemäß einem exemplarischen Ausführungsbeispiel findet ein Auskristallisieren von Kupfersulfat aus dem Eisen- und Metallsalz-haltigen Medium 21 der Galvanik 250 statt. Dabei wird z.B. der mit Eisen verunreinigte Bleed 21 erst in Schwefelsäure aufgegeben und anschließend solange eingedampft, bis Kupfer als Kupfersulfat ausfällt. Das unterschiedliche Löslichkeitsprodukt von Kupfersulfat und Eisensulfat ermöglicht, dass das Eisen in Lösung bleibt, während Kupfersulfat aus der Lösung ausfällt. Dieses kann in einem weiteren Schritt abfiltriert werden und einem Rückgewinnen 400 zugeführt werden. Dieser Prozess kann mehrfach wiederholt werden, um eine immer höhere Reinheit der Kupfersulfat (-Kristalle) zu erzielen. In einem exemplarischen Beispiel kann eine sehr hohe Reinheit bereits nach dem zweiten Auskristallisieren erzielt werden. Zusätzlich oder alternativ kann das ausgefallene und abfiltrierte Kupfersulfat nochmals in Schwefelsäure gelöst werden, und dem Ionenaustauschharz 220 zur Eiseneliminierung (Entfernen von Rest-Eisen) zuführt werden.

In einem weiteren Beispiel kann das Kupfersulfat dem Galvanikprozess 250 direkt zurückgeführt werden. Während der Galvanisierung kann Kupfer in Form von Kupfersulfat dem Elektrolyten zudosiert werden. In diesem speziellen Ausführungsbeispiel kann auf ein Rückgewinnen 400 (z.B. über Elektrolyse) verzichtet werden. Dies kann dadurch ermöglicht sein, dass ein wesentlicher Teil des Fremdmetalls (insbesondere des Eisens) entfernt worden ist. Hierbei müsste dann nur der aufbereitete Teilstrom 1 aus dem Ätzprozess 150 elektrolytisch aufbereitet werden. Dies kann dann zu einem sortenreinen Rückgewinnen (Teilstrom 1 (optional Teilstrom 3), nicht Teilstrom 2) führen.

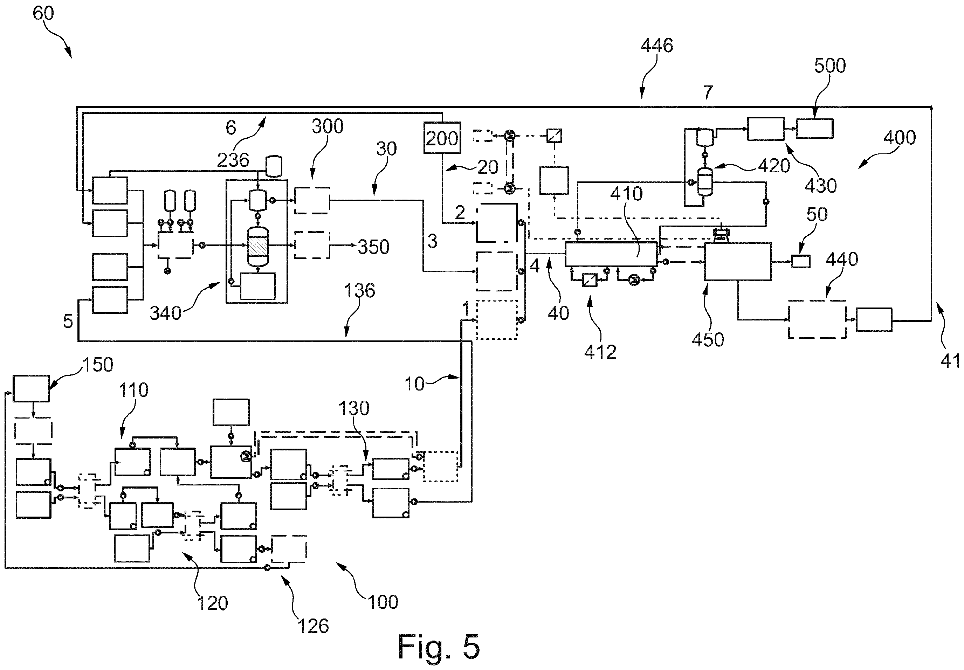

**Figur 5** zeigt eine Übersicht der Aufbereitungsprozesse 100, 200, 300 und des Rückgewinnens 400 bei der Leiterplatten- und/oder Substrat-Herstellung gemäß einem Ausführungsbeispiel der Erfindung. Die Übersicht zeigt die Verzahnung sämtlicher Prozesse ineinander und den sich hieraus ergebenden Wertstoffkreislauf. Sämtliche Prozesse wurden für die oben ausgeführten Ausführungsbeispiele jeweils bereits im Detail diskutiert.

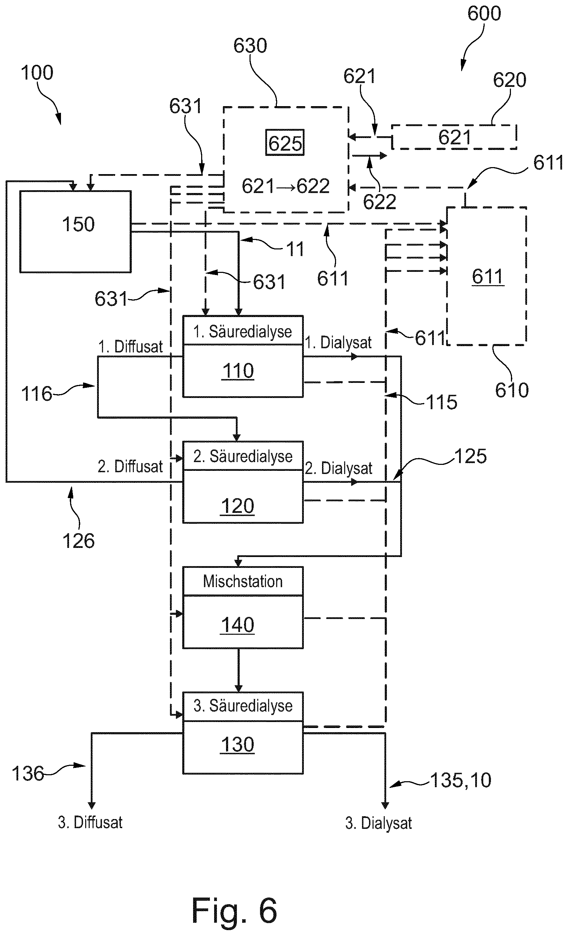

**Figur 6** zeigt eine Prozesskontrollvorrichtung 600 zum Regulieren (bzw. Regeln) von zumindest einem Teil des oben beschriebenen Verfahrens (bzw. der Industrieanlage 60) gemäß einem Ausführungsbeispiel der Erfindung. In dem gezeigten Beispiel ist die Prozesskontrollvorrichtung 600 in den ersten Aufbereitungsprozess 100 zum Bereitstellen des ersten Metallsalz-haltigen Mediums 10 aus einem Ätzprozess 150 aus der Leiterplatten- und/oder Substrat-Herstellung implementiert. Auf dieselbe Weise kann die Prozesskontrollvorrichtung 600 auch in die weiteren (oben beschriebenen) Prozesse (bzw. Verfahren) implementiert werden.

Die Prozesskontrollvorrichtung 600 weist auf: i) eine Datenbank 610 zum Erfassen von zumindest einem Prozessparameter 611 aus dem laufenden (im Betriebszustand befindlichen) Prozess (in dem gezeigten Beispiel der erste Aufbereitungsprozess 100). In dem exemplarischen Ausführungsbeispiel ist gezeigt, dass an allen Prozessschritten Prozessparameter (Werte und/oder Bereiche) 611 erfasst werden (z.B. mittels Sensoren) und der Datenbank 610 zugeführt werden. Die Prozessparameter stellen daher "Ist"-Werte dar (z.B. HCl Konzentration, Kupfer Konzentration, Druckdifferenz, etc). Die Prozesskontrollvorrichtung 600 weist ferner auf: ii) eine Datenmodell-Einheit 620, welche eingerichtet ist zum Speichern von zumindest einem vorbestimmten Prozessparameter 621 (Werte und/oder Bereiche). In dem gezeigten Beispiel werden eine Vielzahl von Prozessparametern gemäß einem oder mehr Datenmodellen in der Datenmodell-Einheit 620 für die verschiedenen Prozessschritte bereitgestellt. Diese vorbestimmten Prozessparameter 621 stellen daher "Soll"-Werte dar. Die Prozesskontrollvorrichtung 600 weist ferner auf: iii) eine Berechnungsvorrichtung 630 (z.B. eine einzelne (separate) Einheit oder eine Mehrzahl von Einheiten), welche eingerichtet ist zum a) Vergleichen des erfassten Prozessparameters 611 (bzw. der Mehrzahl dieser Parameter) mit dem vorbestimmten Prozessparameter 621 (bzw. der Mehrzahl dieser Parameter) (z.B. Vergleich "Ist-Wert" gegen "Soll"-Wert), b) Bestimmen einer Steueroperation 631, welche auf dem Ergebnis des Vergleichens basiert (beispielsweise aktives Ausgleichen einer Differenz zwischen "Ist"-Wert und "Soll"-Wert), und c) Durchführen der bestimmten Steueroperation 631 (z.B. Flussrate anpassen).

Gemäß einem exemplarischen Ausführungsbeispiel der (Software-basierten) Prozesskontrollvorrichtung 600 sammelt die Datenbank 610 Daten aus dem laufenden Prozess (Prozessparameter 611) bzw. greift auf Werte aus einem vorgelagerten Prozessschritt (Prozessparameter 611) zu und archiviert daher (alle) "Ist"-Werte. Ein Datenmodell bzw. mehrere voneinander unabhängige Datenmodelle (welche(s) in der Datenmodell-Einheit 620 z.B. ebenfalls in Form einer Datenbank angelegt sind/ist) beinhalten u.a. "Soll"-Werte (bzw. "Soll"-Bereiche), optional auch deren Zusammenhänge und Variablen (z.B. Datenmodelle 621 als Referenzwerte/Referenzmodelle, die zur Überprüfung der "Ist"-Werte 611 herangezogen werden). Die Berechnungsvorrichtung 630 gleicht die "Ist"-Werte mit den "Soll"-Werten (bzw. setzt einen Rechenschritt basierend auf den Datenmodellen 621 in Kombination mit den "Ist"-Werten 611) ab und setzt anschließend eine Aktion (Steueroperation 631) entsprechend dem Abgleichergebnis (z.B. "Ist"-Wert entspricht "Soll"-Wert, "Ist"-Wert weicht von "Soll"-Wert ab, "Ist"-Wert erfüllt bestimmte Kriterien, etc). Die bestimmte Steueroperation 631 kann (zumindest einen Teil) eines Verfahrensschritts wie oben beschrieben aufweisen.

Gemäß einem exemplarischen Ausführungsbeispiel weist die Berechnungsvorrichtung 630 einen selbstlernenden Algorithmus (AI) 625 (z.B. realisiert mittels neuronaler Netzwerke) auf zum Vergleichen und/oder zum Bestimmen. Der selbstlernende Algorithmus 625 ist eingerichtet, die bestimmte Steueroperation 631 automatisch durchzuführen und/oder einem Benutzer zum Überprüfen bereitzustellen. Ferner ist der selbstlernende Algorithmus 625 eingerichtet basierend auf dem Vergleichen einen neuen vorbestimmten Prozessparameter 622 zu bestimmen und diesen automatisch der Datenmodell-Einheit 620 zuzuführen und/oder dem Benutzer zum Überprüfen bereitzustellen. Bevorzugt ist der selbstlernende Algorithmus 625 eingerichtet, das Ergebnis des Überprüfens durch den Benutzer als Lerngrundlage zu verwenden. Gemäß einem exemplarischen Ausführungsbeispiel weist die Berechnungseinheit 630 einen selbstlernenden Algorithmus 625 auf, der Aktionen (Steueroperationen 631) setzt, welche entweder direkt im System implementiert werden oder die dem Operator zur Überprüfung zur Verfügung gestellt werden. Zudem kann die Entscheidung des Operators bei der Überprüfung wiederum die Lerngrundlage für die AI-Funktion bilden. Ferner kann die AI basierend auf den erfassten "Ist"-Werten 611 neue "Soll"-Werte/Bereiche 621 kreieren bzw. vorschlagen, die dann entweder automatisch oder Operator-gesteuert in das Datenmodell übernommen werden.

In einem spezifischen Ausführungsbeispiel werden die folgenden Prozessparameter 611 überwacht bzw. gemessen (im Folgenden angegeben ist jeweils eine beispielhafte Messmethode) und in der Datenbank 610 erfasst:
i) Füllstände; mittels Ultraschallmessungen,
ii) Volumenströme; mittels Flowmeter,
iii) H₂O₂ Konzentration; über das Redoxpotential bestimmt,
iv) Säure Konzentration; pH Wert (in-line) oder Titration (Proben ziehen),
v) Organik Konzentration; photometrisch (in-line) oder Cyclovoltammetrie (Proben ziehen),
vi) Chlorid Konzentration; Titration (Proben ziehen),
vii) Eisen/Kupfer Konzentration; photometrisch oder Dichtemessungen (in-line) oder Titration (Proben ziehen),
viii) Temperatur; Temperatursensoren (in-line),
ix) Differenzdruck bei der Membrandialyse zwischen Diffusat und Dialysat; Drucksensoren (in-line).

In diesem spezifischen Ausführungsbeispiel werden nach dem Vergleichen (bzw. Auswerten, Datenanalyse) der bestimmten (gemessenen) Prozessparameter 611 und der vorbestimmten Prozessparameter 621 durch die Berechnungsvorrichtung 630 mittels der Berechnungsvorrichtung 630 z.B. die folgenden Steueroperationen 631 (bzw. Aktionen) bestimmt und durchgeführt (bzw. getriggert):
i) Chlorgas-Bildung (z.B.: über Gassensoren); Steueroperation: Elektrolyse aus,
ii) zu hohe Peroxidbelastung; Steueroperation: kein Beladen des Ionentauschers zur Aufbereitung der Spülwässer,
iii) zu niedriger Füllstand; Steueroperation: Pumpen aus,
iv) zu hohe Eisenkonzentration im Elektrolyten; Steueroperation: Zuschalten des Ionenaustauschharzes,
v) zu hohe Säure-Konzentration im Elektrolyten; Steueroperation: Zuschalten des Membrandialyse oder Abpumpen der Elektrolysezelle,
vi) geringe Kupfer-Konzentration im Elektrolyten; Steueroperation: Elektrolysezelle abpumpen und Fördern des Elektrolyten zum Vorbehandlungsbecken der Spülwässer,
vii) zu hoher Differenzdruck bei Membrandialyse; Steueroperation: Volumenströme (Flowrate) anpassen,
viii) Kupfer-Konzentration im Permeat des Ionentauschers zur Aufbereitung der Spülwässer; Steueroperation: Regenerieren,
ix) Eisen-Konzentration im Permeat des Ionentauschers zur Eliminierung von Eisen aus den Galvanikabwässer; Steueroperation: Regenerieren,
x) zu hohe Chlorid-Konzentration im Dialysat; Steueroperation: Volumenströme (Flowrate) anpassen.

### Bezugszeichen

1, 2, 3 Erster Teilstrom, zweiter Teilstrom, dritter Teilstrom 4 Gesamtstrom
5, 6, 7 Erster Abtrennstrom, zweiter Abtrennstrom, dritter Abtrennstrom
52 Metall Rückführung zu Ätzprozess
54 Metall Rückführung zu Galvanisierungsprozess
60 Industrieanlage zum Herstellen gedruckter Leiterplatten
100 Aufbereitung eines Metallsalz-haltigen Mediums aus einem Ätzprozess aus der Herstellung gedruckter Leiterplatten
10 Metallsalz-haltiges Medium
11 Aufzubereitendes Medium
15 Säure
15a Erster Teil Säure
15b Zweiter Teil Säure
15c Dritter Teil Säure
110 Erste Membrandialyse
112 Erste Membran
113 Erster Zulauf
115 Erstes Dialysat
116 Erstes Diffusat
120 Zweite Membrandialyse
122 Zweite Membran
123 Zweiter Zulauf
125 Zweites Dialysat
126 Zweites Diffusat
127 Ätzprozess Sammelbecken
130 Dritte Membrandialyse
131 Zulauf für Dialysat
132 Dritte Membran
133 Dritter Zulauf
135 Drittes Dialysat
136 Drittes Diffusat (erster Abtrennstrom)
140 Reaktor, Mischen und Durchführen der chemischen Reaktion
141 Konzentriertes (Säure-freies) aufzubereitendes Medium
143 Weitere Säure
150 Ätzprozess
151 Ätzprozess Überlaufbecken
160 Verdunster
200 Aufbereitung eines Metallsalz-haltigen Mediums aus einem Galvanisierungsprozess aus der Herstellung gedruckter Leiterplatten
20 Metallsalz-haltiges Medium
21 Eisen- und Metallsalz-haltiges Medium
205 Speicher-Modul, Bereitstellen
210 Oxidier-Modul
220 Separier-Modul, Ionentauscher
221 Beladen
222 Regenerieren, Strömen
225 Saure Lösung
226 Eisen-haltige saure Lösung, Regenerat
230 Aufbereiten, Säuredialyse
231 Bereitstellen an Leiterplatten Prozess
235 Eisen-haltiges Dialysat
236 Säure-haltiges Diffusat (zweiter Abtrennstrom) 240 Rückführen Säure
250 Galvanisierungsprozess
300 Aufbereitung eines Metallsalz-haltigen Mediums aus Spülwasser aus der Herstellung gedruckter Leiterplatten
30 Metallsalz-haltiges Medium
31 Aufzubereitendes Medium, Gesamtabtrennstrom
32 Weiteres Spülwasser
305 Bereitstellen
310 Vorbehandeln
311 Behälter Natronlauge, Einstellen pH-Wert
312 Behälter Bisulfit, chemisches Reduzieren
313 Organik-Filter, Aktivkohlefilter
320 Ionentauscher
321 Beladen
322 Regenerieren, Strömen
325 Regeneriermedium, weitere Säure
326 Regeneriermedium, Regenerat
327 Separieren von Abwasser
328 Speicher-Modul für Regenerat
329 Bereitstellen von konzentriertem Medium
340 Separier-Modul
350 Abfall Medium, Wasser mit Einleitqualität
351 Aufreinigung Wasser
352 Zufuhr Wasser
400 Rückgewinnen eines elementaren Metalls aus einem Metallsalz-haltigen Medium aus der Herstellung gedruckter Leiterplatten
40 Metallsalz-haltiges Medium, Elektrolyt
41 Verbrauchter Elektrolyt
50 Elementares Metall (Kupfer)
401 Rückgewinnen erster Teilstrom
402 Rückgewinnen zweiter und dritter Teilstrom
405 Bereitstellen, Zusammenführen, Aufkonzentrieren
410 Versorgungsbecken, Einstellen der Zusammensetzung
412 Aktivkohlefilter, Filtern
414 Temperaturregelung
415 Pumpvorlage für Separieren von Fremdmetall
416 Verdunster, Aufkonzentrieren
419a,b Fluidkommunikation
420 Ionentauscher, Separieren von Fremdmetall
421 Beladen
422 Regenerieren, Strömen
425 Saure Lösung, Regeneriermedium
426 Regenerat, Fremdmetall-haltige saure Lösung, Regeneriermedium
430 Konzentrierte Fremdmetall-haltige saure Lösung
431 Bereitstellen an Leiterplatten Prozess
440 Membrandialyse, Separieren von Säure
441 Zulauf Dialyse
442 Membran
443 Zulauf Diffusat
445 Dialysat mit Metallsalz
446 Diffusat mit Säure (dritter Abtrennstrom)
447 Speicher-Modul Säure
450 Reaktionszelle, Elektrolysezelle
451 Elektrolyse (E-Modul)
452 Oxidation
455 Ablöse-Modul (L-Modul)
460 Luftzirkulation
461 Abluft
462 Zuluft
463 Luftfilter
464 Gesättigte Abluft
465 Natürliche Verdunstung
500 Weiterer Leiterplatten Prozess, Fotolack-Prozess
600 Prozesskontrollvorrichtung
610 Datenbank
611 Prozessparameter, Ist-Wert
620 Datenmodell-Einheit
621 Vorbestimmter Prozessparameter, Soll-Wert
622 Neuer vorbestimmter Prozessparameter
625 Selbstlernender Algorithmus
630 Berechnungsvorrichtung
631 Bestimmte Steueroperation
P Prozessrichtung

## Patentansprüche

1. Ein Verfahren (200) zum Aufbereiten eines Fremdmetall- und Metallsalz-haltigen Mediums (21) aus der Leiterplatten- und/oder Substrat-Herstellung, insbesondere aus einem Galvanisierungsprozess (250), das Verfahren aufweisend:
Bereitstellen (205) des Fremdmetall- und Metallsalz-haltigen Mediums (21); und
zumindest teilweises Separieren (220) des Fremdmetalls, insbesondere Eisen, aus dem Fremdmetall- und Metallsalz-haltigen Medium (21), um ein Metallsalz-haltiges Medium (20) bereitzustellen.

2. Das Verfahren (200) gemäß Anspruch 1, aufweisend zumindest eines der folgenden Merkmale:
wobei das Fremdmetall zumindest eines aus der Gruppe aufweist, welche besteht aus: Eisen, Blei, Zinn, Molybdän, Nickel, Kobalt, Indium, Cadmium, Zink, Chrom, Natrium, Palladium;
wobei das Metallsalz zumindest ein Metall aus der Gruppe aufweist, welche besteht aus: Kupfer, Nickel, Cobalt, Palladium, Rhodium, Zinn, Cadmium, Magnesium, Natrium, Silber, Gold;
wobei das Metallsalz ein Metallsulfat, insbesondere Kupfersulfat, CuSO₄, aufweist.

3. Das Verfahren (200) gemäß Anspruch 1 oder 2,
wobei das Fremdmetall- und Metallsalz-haltige Medium (21) ein stark saures Medium ist, insbesondere mit einem pH-Wert < 3, insbesondere einem pH-Wert <2, weiter insbesondere einem pH-Wert <1.

4. Das Verfahren (200) gemäß einem beliebigen der vorhergehenden Ansprüche,
wobei das Fremdmetall- und Metallsalz-haltige Medium (21) Schwefelsäure, H₂SO₄, aufweist, insbesondere in einer Konzentration > 50 g/L, insbesondere einer Konzentration > 150 g/L, weiter insbesondere einer Konzentration in dem Bereich 100 bis 200 g/L.

5. Das Verfahren (200) gemäß einem beliebigen der vorhergehenden Ansprüche, aufweisend:
Oxidieren (210) des Fremdmetalls, insbesondere von Fe²⁺ zu Fe³⁺, des Fremdmetall- und Metallsalz-haltigen Mediums (21).

6. Das Verfahren (200) gemäß einem beliebigen der vorhergehenden Ansprüche, wobei das Separieren (220) ferner aufweist:
Verwenden eines Ionentauschers, insbesondere eines Ionentauschers, welcher ein selektives Ionenaustauschharz, weiter insbesondere ein doppel-funktionalisiertes Ionenaustauschharz, aufweist, insbesondere wobei das Verwenden des Ionentauschers aufweist:
Beladen (221) des Ionentauschers (220) mit dem Fremdmetall- und Metall-haltigen Medium (21), insbesondere wobei das Fremdmetall im Wesentlichen oxidiert vorliegt, derart, dass das Fremdmetall im Wesentlichen an dem Ionentauscher (220) verbleibt, insbesondere adsorbiert, um das Metallsalz-haltige Medium (20) bereitzustellen.

7. Das Verfahren (200) gemäß Anspruch 6, ferner aufweisend:
nachfolgend dem Beladen (221), Regenerieren (222) des Ionentauschers (220) mittels Strömens einer sauren Lösung (225) durch den Ionentauscher (220) derart, dass das Fremdmetall in der sauren Lösung (225) gelöst wird und eine Fremdmetall-haltige saure Lösung (226) bereitgestellt wird;

8. Das Verfahren (200) gemäß Anspruch 7, ferner aufweisend zumindest eines der folgenden Merkmale:
Aufbereiten (230) der Fremdmetall-haltigen sauren Lösung (226) mittels einer Säuredialyse, um ein Fremdmetall-haltiges Dialysat (235), insbesondere Eisenchlorid-haltig, und ein Säure-haltiges Diffusat (236) bereitzustellen;
Bereitstellen (231) der Fremdmetall-haltigen sauren Lösung (226), insbesondere eines Eisen-haltigen Dialysats (235), an einen weiteren Prozess (500) der Leiterplatten- und/oder Substrat-Herstellung, insbesondere einem Prozess zum Fällen von Fotolack;
wobei die Säuredialyse (230) mittels Membrandialyse durchgeführt wird, insbesondere wobei zumindest eine Membran der Membrandialyse eine Wickelmembran oder eine Plattenmembran aufweist;
Bereitstellen des Säure-haltigen Diffusats (236) als zweiter Abtrennstrom (6) an zumindest einen Prozess zur Leiterplatten- und/oder Substrat-Herstellung aus der Gruppe, welche besteht aus:
einem Verfahren (300) zum Aufbereiten von Spülwässern,
einem Ätzprozess (150),
einem Trennprozess,
der Säuredialyse (230),
dem Regenerieren (222);
kontinuierliches Rückführen (240) des Säure-haltigen Diffusats (236), insbesondere nach einem Aufbereiten, zu der Säuredialyse (230) oder dem Regenerieren (222) des Ionentauschers (220);
wobei die saure Lösung (225) Salzsäure, HCl, aufweist, und wobei die aufbereitete Fremdmetall-haltige saure Lösung (226) Eisenchlorid, FeCl₃, aufweist.

9. Das Verfahren (200) gemäß einem beliebigen der Ansprüche 1 bis 5, aufweisend:
zumindest teilweises thermisches Separieren, insbesondere
ferner aufweisend:
Eindampfen des Fremdmetall- und Metallsalz-haltigen Mediums (21), welches insbesondere Schwefelsäure aufweist, derart, dass das Metallsalz auskristallisiert und das Fremdmetall, insbesondere Eisen, in einem Fremdmetall-haltigen Medium verbleibt; und
Separieren des Fremdmetall-haltigen Mediums von dem Metallsalz, insbesondere Überführen des Metallsalzes in das Metallsalz-haltige Medium (20).

10. Das Verfahren (200) gemäß einem beliebigen der vorhergehenden Ansprüche, ferner aufweisend zumindest eines der folgenden Merkmale:
wobei das Separieren (220), insbesondere das Beladen (221) und/oder das Regenerieren (222), kontinuierlich betrieben wird;
wobei das Verfahren weiter aufweist:
Aufkonzentrieren des Metallsalzes in dem Metallsalz-haltigen Medium (20), insbesondere mittels eines Verdunsters;
wobei das Verfahren weiter aufweist:
Rückgewinnen (400) von elementarem Metall (50) aus dem Metallsalz-haltigen Medium (20) in einer Reaktionszelle (450), insbesondere mittels Elektrolyse (451).

11. Eine Vorrichtung (200) zum Aufbereiten eines Fremdmetall- und Metallsalz-haltigen Mediums (21) aus der Leiterplatten- und/oder Substrat-Herstellung, insbesondere aus einem Galvanisierungsprozess (250), die Vorrichtung (200) aufweisend:
ein Speicher-Modul (205) zum Bereitstellen des Fremdmetall- und Metallsalz-haltigen Mediums (21); und
ein Separier-Modul (220), welches insbesondere einen Kationentauscher aufweist, zum zumindest teilweisen Separieren des Fremdmetall, insbesondere Eisen, aus dem Fremdmetall- und Metallsalz-haltigen Medium (21), um ein Metallsalz-haltiges Medium (20) bereitzustellen.

12. Ein Verwenden eines Eisen- und Metallsalz-haltigen Mediums (21) aus einem Galvanisierungsprozess (250) zur Leiterplatten- und/oder Substrat-Herstellung als Ausgangsmaterial (231) zur, insbesondere kontinuierlichen, Produktion von Eisenchlorid für das Fällen von Fotolack für die Herstellung der Leiterplatten und/oder der Substraten.

13. Eine Prozesskontrollvorrichtung (600) zum Regulieren eines Verfahrens gemäß einem beliebigen der Ansprüche 1 bis 10 und/oder einer Vorrichtung gemäß Anspruch11, wobei die Prozesskontrollvorrichtung (600) aufweist:
eine Datenbank (610) zum Erfassen von zumindest einem Prozessparameter (611) aus dem laufenden Prozess;
eine Datenmodell-Einheit (620), welche eingerichtet ist zum Speichern von zumindest einem vorbestimmten Prozessparameter (621); und
eine Berechnungsvorrichtung (630), welche eingerichtet ist zum Vergleichen des erfassten Prozessparameters (611) mit dem vorbestimmten Prozessparameter (621),
Bestimmen einer Steueroperation (631), welche auf dem Ergebnis des Vergleichens basiert, und
Durchführen der bestimmten Steueroperation (631).

14. Die Prozesskontrollvorrichtung (600) gemäß Anspruch 13, ferner aufweisend zumindest eines der folgenden Merkmale:
wobei die Berechnungsvorrichtung (630) einen selbstlernenden Algorithmus (625), insbesondere mittels neuronaler Netzwerke, zum Vergleichen und/oder zum Bestimmen aufweist;
wobei der selbstlernende Algorithmus (625) eingerichtet ist, die bestimmte Steueroperation (631) automatisch durchzuführen, und/oder wobei der selbstlernende Algorithmus (625) eingerichtet ist, die bestimmte Steueroperation (631) einem Benutzer zum Überprüfen bereitzustellen;
wobei der selbstlernende Algorithmus (625) eingerichtet ist basierend auf dem Vergleichen einen neuen vorbestimmten Prozessparameter (622) zu bestimmen und automatisch der Datenmodell-Einheit (620) zuzuführen, und/oder wobei der selbstlernende Algorithmus (625) eingerichtet ist basierend auf dem Vergleichen einen neuen vorbestimmten Prozessparameter (622) zu bestimmen und dem Benutzer zum Überprüfen bereitzustellen;
wobei der selbstlernende Algorithmus (625) eingerichtet ist, das Ergebnis des Überprüfens durch den Benutzer als Lerngrundlage zu verwenden.

15. Ein Computerprogramm-Produkt zum Steuern eines Verfahrens (200) zum Aufbereiten eines Fremdmetall- und Metallsalz-haltigen Mediums (21) aus der Leiterplatten und/oder Substrat Herstellung, welches Computerprogramm-Produkt, wenn es von einem oder mehreren Prozessoren ausgeführt wird, das Verfahren nach einem der Ansprüche 1 bis 10 und/oder die Vorrichtung nach Anspruch 11 und/oder die Prozesskontrollvorrichtung 600 nach Ansprüche 13 oder 14 steuert.
